# EUROPEAN PATENT APPLICATION

(11) **EP 4 685 656 A1**
(43) Date of publication of application: **28.01.2026**
(21) Application number: 25159957.7
(22) Date of filing: 25.02.2025
(51) Int. Cl.: G06F 13/16, G06F 13/40, G06F 13/42, G11C 7/10

(54) **MEMORY DEVICE INCLUDING ON-DIE TERMINATION CIRCUIT, STORAGE CONTROLLER, AND STORAGE DEVICE INCLUDING THE SAME**

(30) Priority: 24.07.2024 KR 20240097892
(71) Applicant: Samsung Electronics Co., Ltd., Suwon-si, Gyeonggi-do 16677 (KR)
(72) Inventor: JANG, Jonghyun, Suwon-si, Gyeonggi-do 16677 (KR); JEONG, Hangil, Suwon-si, Gyeonggi-do 16677 (KR); JO, Youngmin, Suwon-si, Gyeonggi-do 16677 (KR)
(74) Representative: Kuhnen & Wacker Patent- und Rechtsanwaltsbüro PartG mbB

(57) **Abstract**

A storage device (1000) may include a plurality of non-volatile memory devices (1110, 1120, 1210, 1220) including an on-die termination (ODT) circuit (160, 160a, 160b, 160c), respectively, and a storage controller (1300) configured to provide a first read command to a first non-volatile memory device (1110) among the plurality of non-volatile memory devices (1110, 1120, 1210, 1220), provide an ODT enable command to the plurality of non-volatile memory devices (1110, 1120, 1210, 1220), enable the ODT circuits (160, 160a, 160b, 160c) of the plurality of non-volatile memory devices (1110, 1120, 1210, 1220) in response to the ODT enable command, provide a first selection chip enable (SCE) command to the first non-volatile memory device (1110), and in response to the first SCE command (SCE1), disable a first ODT circuit (160) included in the first non-volatile memory device (1110) among the ODT circuits (160, 160a, 160b, 160c)of the plurality of non-volatile memory devices (1110, 1120, 1210, 1220), and output data stored in the first non-volatile memory device.

## Description

### BACKGROUND OF THE INVENTION

### (a) Field of the Invention

The present disclosure relates to a memory device including an on-die termination (ODT) circuit, a storage controller, and a storage device including the same.

### (b) Description of the Related Art

A storage device may include a plurality of non-volatile memory devices and a storage controller for controlling the plurality of non-volatile memory devices. The plurality of non-volatile memory devices may include a plurality of on-die termination circuits to decrease signal reflection generated during the process of transmitting and receiving data signals with respect to the storage controller, respectively. The operation of the plurality of on-die termination circuits may be controlled by the commands provided by the storage controller. It may take time for the storage controller to control the operations of the plurality of on-die termination circuits through commands, respectively. Therefore, it is useful to speed up the operation of the storage device by reducing the number of commands.

### SUMMARY

The present disclosure attempts to provide a memory device, a storage controller, and a storage device including the same capable of decreasing the time required for data communication for operation of an on-die termination circuit. The invention is set out in the appended claims.

A storage device may include a plurality of non-volatile memory devices including a plurality of on-die termination (ODT) circuits, respectively, and a storage controller configured to provide a first read command to a first non-volatile memory device among the plurality of non-volatile memory devices, provide an ODT enable command to the plurality of non-volatile memory devices, enable the plurality of ODT circuits in response to the ODT enable command, provide a first selection chip enable (SCE) command to the first non-volatile memory device, and in response to the first SCE command, disable a first ODT circuit included in the first non-volatile memory device among the plurality of ODT circuits, and output data stored in the first non-volatile memory device.

A memory device may include a memory cell array including a plurality of memory cells, a plurality of page buffers connected to the plurality of memory cells, an on-die termination (ODT) circuit including a termination resistor, and configured to perform a termination operation including an ODT enable operation in which the termination resistor connected to a data line through which data are input and output is connected to a power source voltage and an ODT disable operation in which the connection between the termination resistor and the power source voltage is blocked, an ODT mode register configured to store ODT operation mode information on whether the ODT circuit is to perform the termination operation, and a control logic circuit configured to identify the ODT operation mode information in response to a selection chip enable (SCE) command received from the outside, and based on the ODT operation mode information, control the ODT circuit to perform the ODT disable operation, and control the plurality of page buffers to output the data stored in the plurality of page buffers to the outside through the data line.

A storage controller may include a command queue configured to provide a first read command to a first non-volatile memory device among a plurality of non-volatile memory devices, provide an on-die termination (ODT) enable command by which a plurality of ODT circuits included in the plurality of non-volatile memory devices, respectively, are enabled to the plurality of non-volatile memory devices, provide a first selection chip enable (SCE) command and a first selection chip termination (SCT) command to the first non-volatile memory device, and store a plurality of additional read commands, a plurality of additional SCE commands, and a plurality of additional SCT commands to be provided to remaining non-volatile memory devices excluding the first non-volatile memory device from among the plurality of non-volatile memory devices, and a processor configured to generate an ODT disable command by which the plurality of ODT circuits are disabled based on whether the plurality of additional SCT commands are stored in the command queue.

### BRIEF DESCRIPTION OF THE DRAWINGS

FIG. 1 is a drawing for explaining a storage device according to an embodiment.
FIG. 2 is a drawing for explaining pins of a storage controller and a non-volatile memory device according to an embodiment.
FIG. 3 is a drawing for explaining a connection relationship between a storage controller and a plurality of non-volatile memory devices according to an embodiment.
FIG. 4 is a drawing for explaining a command/address (CA) packet transmitted through a command/address line according to an embodiment.
FIG. 5 is a drawing for explaining a header and a body included in a CA packet according to an embodiment.
FIG. 6 is a drawing for explaining a first non-volatile memory device according to an embodiment.
FIG. 7 is a drawing for explaining a storage device for performing a read operation, a data output operation, and a termination operation according to an embodiment.
FIG. 8 is a drawing for explaining the non-volatile memory device configured to disable an on-die termination (ODT) circuit in response to a target on-die termination disable command, and output data in response to a selection chip enable command, according to an embodiment.
FIG. 9 is a drawing for explaining a plurality of on-die termination circuits enabled or disabled while performing a data output operation according to an embodiment.
FIG. 10 is a drawing for explaining a plurality of non-volatile memory devices for changing ODT operation mode information according to an ODT mode change command according to an embodiment.
FIG. 11 is a drawing for explaining a storage controller activating a flag signal while providing commands to a plurality of non-volatile memory devices according to an embodiment.
FIG. 12 is a drawing for explaining a storage controller generating an ODT disable command to disable a plurality of on-die termination circuits, when a flag signal according to an embodiment is inactivated.
FIG. 13 is a drawing for explaining the non-volatile memory device disabling an on-die termination circuit and outputting the data in response to a selection chip enable command according to an embodiment.
FIG. 14 is a drawing for explaining a plurality of non-volatile memory devices performing a read operation, a data output operation, an ODT enable operation, and an ODT disable operation according to commands received through a command/address line according to an embodiment.
FIG. 15 is a flowchart for explaining an operation of a storage device according to an embodiment.
FIG. 16 is a flowchart for explaining the non-volatile memory device performing an ODT disable operation in response to a selection chip enable command according to an embodiment.
FIG. 17 is a flowchart for explaining the non-volatile memory device performing an ODT enable operation in response to a selection chip termination command according to an embodiment.
FIG. 18 is a flowchart for explaining a storage controller generating an ODT disable command based on a flag signal according to an embodiment.

### DETAILED DESCRIPTION OF THE EMBODIMENTS

The present disclosure will be described more fully hereinafter with reference to the accompanying drawings, in which exemplary embodiments of the disclosure are illustrated. As those skilled in the art would realize, the described embodiments may be modified in various different ways, all without departing from the spirit or scope of the present disclosure.

The drawings and description are to be regarded as illustrative in nature and not restrictive, and like reference numerals designate like elements throughout the specification.

In addition, unless explicitly described to the contrary, the word "comprise" and variations such as "comprises" or "comprising", will be understood to imply the inclusion of stated elements but not the exclusion of any other elements.

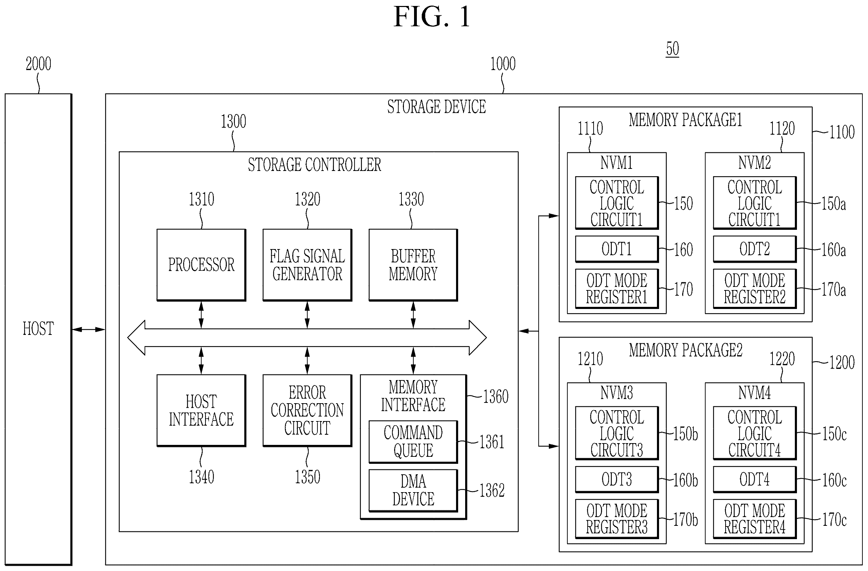

FIG. 1 is a drawing for explaining a storage device according to an embodiment.

Referring to FIG. 1, an electronic system 50 may include a storage device 1000 and a host 2000.

The storage device 1000 may be a device that stores data under the control of the host 2000. In an embodiment, the storage device 1000 may be manufactured in a form of a solid state drive (SSD) or a universal flash storage (UFS).

In an embodiment, the storage device 1000 may include a plurality of memory packages and storage controllers 1300. In an embodiment, the plurality of memory packages may include a first memory package 1100 and a second memory package 1200. Each of the first memory package 1100 and the second memory package 1200 may include a plurality of non-volatile memory devices. In an embodiment, the first memory package 1100 may include a first non-volatile memory device 1110 and a second non-volatile memory device 1120, and the second memory package 1200 may include a third non-volatile memory device 1210 and a fourth non-volatile memory device 1220.

In an embodiment, the first to fourth non-volatile memory devices 1110, 1120, 1210, and 1220 may store the data. The first to fourth non-volatile memory devices 1110, 1120, 1210, and 1220 may operate in response to a control of the storage controller 1300. In an embodiment, each of the first to fourth non-volatile memory devices 1110, 1120, 1210, and 1220 may be a NAND flash memory. Each of the first to fourth non-volatile memory devices 1110, 1120, 1210, and 1220 may include a plurality of memory blocks that stores the data. Each of the plurality of memory blocks may include a plurality of memory cells.

In an embodiment, each of the first to fourth non-volatile memory devices 1110, 1120, 1210, and 1220 may receive command and address from the storage controller 1300, and may perform an operation indicated by a command with respect to a region selected by the address. Each of the first to fourth non-volatile memory devices 1110, 1120, 1210, and 1220 may perform a program operation (i.e., write operation) for storing the data in the region selected by the address, a read operation for reading the data, or an erase operation for deleting the data.

In an embodiment, each of the first to fourth non-volatile memory devices 1110, 1120, 1210, and 1220 may include a control logic circuit, an on-die termination circuit, and an on-die termination (ODT) mode register. In an embodiment, the first non-volatile memory device 1110 may include a first control logic circuit 150, a first on-die termination circuit 160, and a first ODT mode register 170. The second non-volatile memory device 1120 may include a second control logic circuit 150a, a second on-die termination circuit 160a, and a second ODT mode register 170a. The third non-volatile memory device 1210 may include a third control logic circuit 150b, a third on-die termination circuit 160b, and a third ODT mode register 170b. The fourth non-volatile memory device 1220 may include a fourth control logic circuit 150c, a fourth on-die termination circuit 160c, and a fourth ODT mode register 170c.

In an embodiment, the first to fourth control logic circuits 150, 150a, 150b, and 150c may control operations of the first to fourth non-volatile memory devices 1110, 1120, 1210, and 1220, respectively. The first to fourth control logic circuits 150, 150a, 150b, and 150c may control the first to fourth non-volatile memory devices 1110, 1120, 1210, and 1220 to perform the program operation, the read operation, or the erase operation in response to a command received from the storage controller 1300, respectively.

In an embodiment, the first to fourth control logic circuits 150, 150a, 150b, and 150c may control the first to fourth on-die termination circuits 160, 160a,160b, and 160c to perform a termination operation including an ODT enable operation in which the first to fourth on-die termination circuits 160, 160a, and 160b, and 160c are enabled and an ODT disable operation in which the first to fourth on-die termination circuits 160, 160a, 160b, and 160c are disabled. Each of the first to fourth on-die termination circuits 160, 160a, 160b, and 160c may include a termination resistor connected to the data line through which the data is input and output. The ODT enable operation may be an operation in which the termination resistor included in the first to fourth on-die termination circuits 160, 160a, and 160b, and 160c, respectively, is connected to a power source voltage. The ODT disable operation may be an operation in which the connection between the termination resistor and the power source voltage is blocked.

In an embodiment, the first to fourth ODT mode registers 170, 170a, 170b, and 170c may store ODT operation mode information, respectively. The ODT operation mode information may include information on whether to perform the termination operation. In an embodiment, the ODT operation mode information may include ODT skip information corresponding to a skip of the termination operation or ODT operation information corresponding to performing of the termination operation.

In an embodiment, the first to fourth control logic circuits 150, 150a, 150b, and 150c may control first to fourth on-die termination circuits to perform the termination operation based on the ODT operation mode information stored in the first to fourth ODT mode registers 170, 170a, 170b, and 170c, respectively. In an embodiment, the first to fourth control logic circuits 150, 150a, 150b, and 150c may identify the ODT operation mode information stored in the first to fourth ODT mode registers 170, 170a, 170b, and 170c, respectively, in response to a selection chip enable command or a selection chip termination command received from the storage controller 1300, and may control the first to fourth on-die termination circuits 160, 160a, 160b, and 160c to perform the termination operation based on the ODT operation mode information, or skip the performing of the termination operation.

In an embodiment, the first to fourth control logic circuits 150, 150a, 150b, and 150c may control the first to fourth ODT mode registers 170, 170a, 170b, and 170c to set the ODT operation information or the ODT skip information as the ODT operation mode information in response to an ODT operation mode change command received from the storage controller 1300.

The storage controller 1300 may control an overall operation of the storage device 1000.

In an embodiment, when power is applied to the storage device 1000, the storage controller 1300 may execute firmware. The firmware may include a host interface layer controlling communication with respect to the host 2000, a flash translation layer controlling communication between the host 2000 and the first to fourth non-volatile memory devices 1110, 1120, 1210, and 1220, and a memory interface layer controlling communication with respect to the first to fourth non-volatile memory devices 1110, 1120, 1210, and 1220. In an embodiment, the flash translation layer may convert a logical address of the host 2000 into a physical address of the first to fourth non-volatile memory devices 1110, 1120, 1210, and 1220.

In an embodiment, the storage controller 1300 may control the first to fourth non-volatile memory devices 1110, 1120, 1210, and 1220 to perform the write operation, the read operation, the erase operation, or the like according to a request from the host 2000. At the time of the write operation, the storage controller 1300 may provide a write command, an address, and the data to the first to fourth non-volatile memory devices 1110, 1120, 1210, and 1220. At the time of the read operation, the storage controller 1300 may provide a read command and address to the first to fourth non-volatile memory devices 1110, 1120, 1210, and 1220. At the time of the erase operation, the storage controller 1300 may provide an erase command and address to the first to fourth non-volatile memory devices 1110, 1120, 1210, and 1220.

In an embodiment, the storage controller 1300 may include a processor 1310, a flag signal generator 1320, a buffer memory 1330, a host interface 1340, an error correction circuit 1350, and a memory interface 1360.

The processor 1310 may control an overall operation of the storage controller 1300. The processor 1310 may generate commands according to the request of the host 2000. In an embodiment, the processor 1310 may generate the read command according to a read request of the host 2000. The processor 1310 may generate the selection chip enable command and the selection chip termination command, related to the data output. The processor 1310 may generate an ODT enable command by which the first to fourth on-die termination circuits 160, 160a, 160b, and 160c are enabled and an ODT disable command by which the first to fourth on-die termination circuits 160, 160a, 160b, and 160c are disabled. The processor 1310 may generate the ODT operation mode change command to change operation modes of first to fourth on-die termination circuits. The processor 1310 may provide the generated commands to the memory interface 1360. The processor 1310 may control the memory interface 1360 to provide the commands to the first to fourth non-volatile memory devices 1110, 1120, 1210, and 1220.

The flag signal generator 1320 may generate a flag signal. The flag signal generator 1320 may activate or inactivate the flag signal according to the control of the processor 1310. In an embodiment, while the commands generated by the processor 1310 is being provided to the first to fourth non-volatile memory devices1110, 1120, 1210, and 1220, the flag signal generator 1320 may activate the flag signal. After the selection chip enable command and the selection chip termination command related to the data output is provided to the first to fourth non-volatile memory devices1110, 1120, 1210, and 1220, the flag signal generator 1320 may inactivate the flag signal. In an embodiment, the processor 1310 may generate the ODT disable command by which the first to fourth on-die termination circuits 160, 160a, 160b, and 160c are disabled based on whether the flag signal is activated.

In an embodiment, the buffer memory 1330 may be used as a cache memory, an operating memory, or the like, of the storage controller 1300.

In an embodiment, the buffer memory 1330 may temporarily store the data provided from the host 2000, or may temporarily store the data read from the first to fourth non-volatile memory devices 1110, 1120, 1210, and 1220. In an embodiment, the buffer memory 1330 may be a dynamic random-access memory (DRAM) or a static random-access memory (SRAM). In an embodiment, the buffer memory 1330 may be located inside the storage controller 1300, or outside the storage controller 1300.

In an embodiment, the host interface 1340 may communicate with the host 2000. The host interface 1340 may receive the data from the host 2000, or provide the data to the host 2000.

In an embodiment, the error correction circuit 1350 may perform an encoding operation to generate parity data with respect to the data received from the host 2000. The encoded data may be provided to the first to fourth non-volatile memory devices 1110, 1120, 1210, and 1220 through the memory interface 1360. The error correction circuit 1350 may perform a decoding operation with respect to the data read from the first to fourth non-volatile memory devices 1110, 1120, 1210, and 1220. The error correction circuit 1350 may perform the decoding operation and thereby correct error bits included in the data read from the first to fourth non-volatile memory devices 1110, 1120, 1210, and 1220. The error correction circuit 1350 may provide the decoded data to the host 2000 through the host interface 1340.

In an embodiment, the memory interface 1360 may communicate with the first to fourth non-volatile memory devices 1110, 1120, 1210, and 1220. The memory interface 1360 may provide the data to the first to fourth non-volatile memory devices 1110, 1120, 1210, and 1220 or may receive the data from the first to fourth non-volatile memory devices 1110, 1120, 1210, and 1220.

In an embodiment, the memory interface 1360 may include a command queue 1361 and a direct memory access (DMA) device 1362. In an embodiment, the command queue 1361 may store the commands generated from the processor 1310. The command queue 1361 may provide the commands to the first to fourth non-volatile memory devices 1110, 1120, 1210, and 1220 according to the control of the processor 1310. In an embodiment, the DMA device 1362 may receive the data from the first to fourth non-volatile memory devices 1110, 1120, 1210, and 1220.

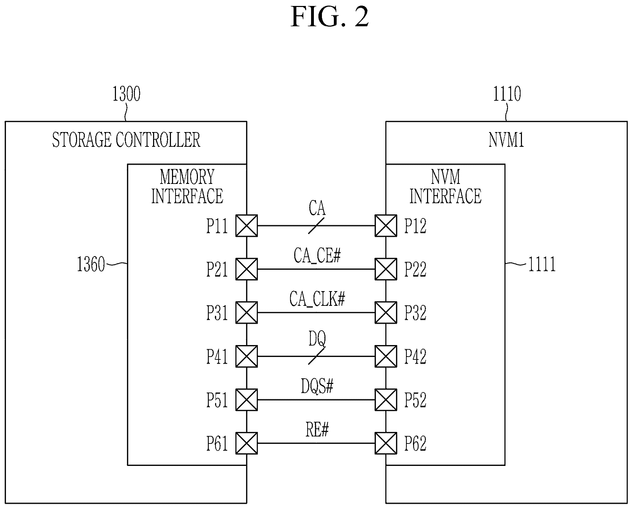

FIG. 2 is a drawing for explaining pins of the storage controller and a non-volatile memory device according to an embodiment.

Referring to FIG. 2, the storage controller 1300 and the first non-volatile memory device 1110 may transmit and receive signals through a plurality of lines connected to a plurality of pins. In an embodiment, the storage controller 1300 may include the memory interface 1360. The memory interface 1360 may include an eleventh pin P11, a twenty-first pin P21, a thirty-first pin P31, a forty-first pin P41, a fifty-first pin P51, and a sixty-first pin P61. The first non-volatile memory device 1110 may include an NVM interface 1111. The NVM interface 1111 may include a twelfth pin P12, a twenty-second pin P22, a thirty-second pin P32, a forty-second pin P42, a fifty-second pin P52, and a sixty-second pin P62.

In an embodiment, a command/address line CA may be connected to the eleventh pin P11 and the twelfth pin P12. The storage controller 1300 may provide the command and address to the first non-volatile memory device 1110 through the command/address line CA.

In an embodiment, a command/address chip enable line CA_CE# may be connected to the twenty-first pin P21 and the twenty-second pin P22. The storage controller 1300 may provide a chip enable signal to the first non-volatile memory device 1110 through the command/address chip enable line CA_CE#. The chip enable signal may be a signal for selecting the non-volatile memory device to provide the command and address through the command/address line CA_CE#.

In an embodiment, a command/address clock line CA_CLK# may be connected to the thirty-first pin P31 and the thirty-second pin P32. The storage controller 1300 may provide a command/address clock signal to the first non-volatile memory device 1110 through the command/address clock line CA_CLK#. The command/address clock signal may be toggled when the command and address is provided to the first non-volatile memory device 1110 through the command/address line. In an embodiment, the first non-volatile memory device 1110 may receive the command and address from the storage controller 1300 in response to a rising edge and falling edge of the command/address clock signal.

In an embodiment, the data line DQ may be connected to the forty-first pin P41 and the forty-second pin P42. In an embodiment, the storage controller 1300 may provide the data to the first non-volatile memory device 1110 through the data line DQ. In an embodiment, the first non-volatile memory device 1110 may provide the data to the storage controller 1300 stored in the first non-volatile memory device 1110 through the data line DQ.

In an embodiment, the data strobe line DQS# may be connected to the fifty-first pin P51 and the fifty-second pin P52. In an embodiment, the storage controller 1300 may provide the data strobe signal to the first non-volatile memory device 1110 through the data strobe line DQS#. The data strobe signal may be toggled when the data is provided from the storage controller 1300 to the first non-volatile memory device 1110 through the data line DQ. The data strobe signal may be toggled when the data is provided from the first non-volatile memory device 1110 to the storage controller 1300 through the data line DQ. The storage controller 1300 or the first non-volatile memory device 1110 may receive the data in response to a rising edge and a falling edge of the data strobe signal.

In an embodiment, a read enable line RE# may be connected to the sixty-first pin

P61 and the sixty-second pin P62. In an embodiment, the storage controller 1300 may provide a read enable signal to the first non-volatile memory device 1110 through the read enable line RE#. The read enable signal may be toggled when the data is provided from the first non-volatile memory device 1110 to the storage controller 1300 through the data line.

In an embodiment, although the first non-volatile memory device 1110 is described with reference to FIG. 2 as an example, the second to the fourth non-volatile memory devices 1120, 1210, and 1220 of FIG. 1 may also be connected to the storage controller 1300 through the command/address line CA, the command/address chip enable line CA_CE#, the command/address clock line CA_CLK#, the data line DQ, the data strobe line DQS#, the read enable line RE#, the same as in the first non-volatile memory device 1110.

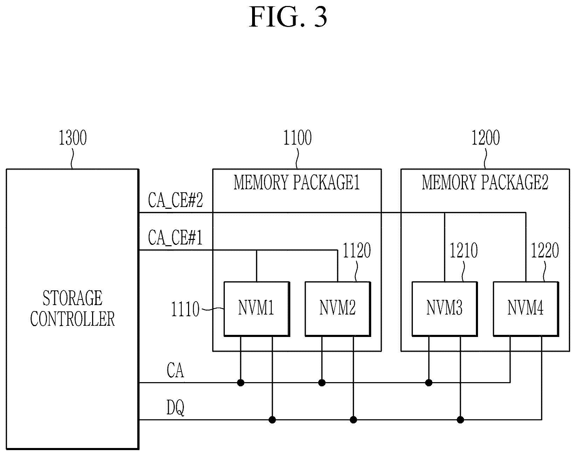

FIG. 3 is a drawing for explaining a connection relationship between the storage controller and the plurality of non-volatile memory devices according to an embodiment.

Referring to FIG. 3, the first non-volatile memory device 1110 and the second non-volatile memory device 1120 included in the first memory package 1100 may be connected to the storage controller 1300 through a first command/address chip enable line CA_CE#1. The storage controller 1300 may output the chip enable signal selecting the non-volatile memory device to provide the command and address from among the first non-volatile memory device 1110 and the second non-volatile memory device 1120 through the first command/address chip enable line CA_CE#1.

The third non-volatile memory device 1210 and the fourth non-volatile memory device 1220 included in the second memory package 1200 may be connected to the storage controller 1300 through a second command/address chip enable line CA_CE#2. A storage controller 1030 may output the chip enable signal selecting the non-volatile memory device to provide the command and address from among the third non-volatile memory device 1210 and the fourth non-volatile memory device 1220 through the second command/address chip enable line CA_CE#2.

In an embodiment, the first to fourth non-volatile memory devices 1110, 1120, 1210, and 1220 may be commonly connected to the command/address line CA. The first to fourth non-volatile memory devices 1110, 1120, 1210, and 1220 may receive the command and address from the storage controller 1300 through the command/address line CA.

In an embodiment, the first to fourth non-volatile memory devices 1110, 1120, 1210, and 1220 may be commonly connected to the data line DQ. The first to fourth non-volatile memory devices 1110, 1120, 1210, and 1220 may provide the data to the storage controller 1300 through the data line DQ. The first to fourth non-volatile memory devices 1110, 1120, 1210, and 1220 may receive the data from the storage controller 1300 through the data line DQ.

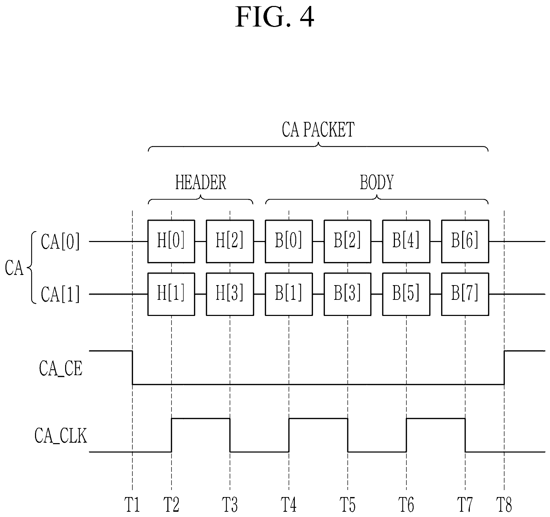

FIG. 4 is a drawing for explaining a command/address (CA) packet transmitted through the command/address line according to an embodiment.

Referring to FIG. 4, the storage controller and the first to fourth non-volatile memory devices 1110, 1120, 1210, and 1220 may transmit and/or receive commands, addresses, or data according to Separate Command Address (SCA) protocol. In an embodiment, the SCA protocol may be a protocol by which the command and address is transmitted through the command/address line CA, and data to be stored in the first to fourth non-volatile memory devices 1110, 1120, 1210, and 1220 or the data read from the first to fourth non-volatile memory devices 1110, 1120, 1210, and 1220 are input and output through the data line DQ.

In an embodiment, one command or one address transmitted through the command/address line CA may include a CA packet. The CA packet may include a header HEADER and a body BODY. The header HEADER may be the data representing the type of the CA packet. In an embodiment, the header HEADER may include the data representing that the type of the CA packet is a command or address. The header HEADER may include a zero-th header H[0], a first header H[1], a second header H[2], and a third header H[3]. In an embodiment, the body BODY may be data including additional information related to the header HEADER. In an embodiment, the body BODY may include a zero-th body B[0], a first body B[1], a second body B[2], a third body B[3], a fourth body B[4], a fifth body B[5], a sixth body B[6], and a seventh body B[7].

In an embodiment, when there are two command/address lines CA, the storage controller 1300 may provide the CA packet to the first to fourth non-volatile memory devices 1110, 1120, 1210, and 1220 through a zero-th command/address line CA[0] and a first command/address line CA[1]. While the CA packet is being provided to the first to fourth non-volatile memory devices 1110, 1120, 1210, and 1220, a level of the chip enable signal CA_CE may transition from a high level to a low level.

In an embodiment, while the CA packet is being provided to the first to fourth non-volatile memory devices 1110, 1120, 1210, and 1220, a command/address clock signal CA_CLK may be toggled. In an embodiment, the first to fourth non-volatile memory devices 1110, 1120, 1210, and 1220 may receive the zero-th header H[0] and the first header H[1] in response to a rising edge of the command/address clock signal CA_CLK, and may receive the second header H[2] and the third header H[3] in response to a falling edge of the command/address clock signal CA_CLK. In the same way, the first to fourth non-volatile memory devices 1110, 1120, 1210, and 1220 may receive the zero-th to seventh bodies B[0] to B[7] transmitted from the storage controller 1300 in response to the rising edge and the falling edge of the command/address clock signal CA_CLK.

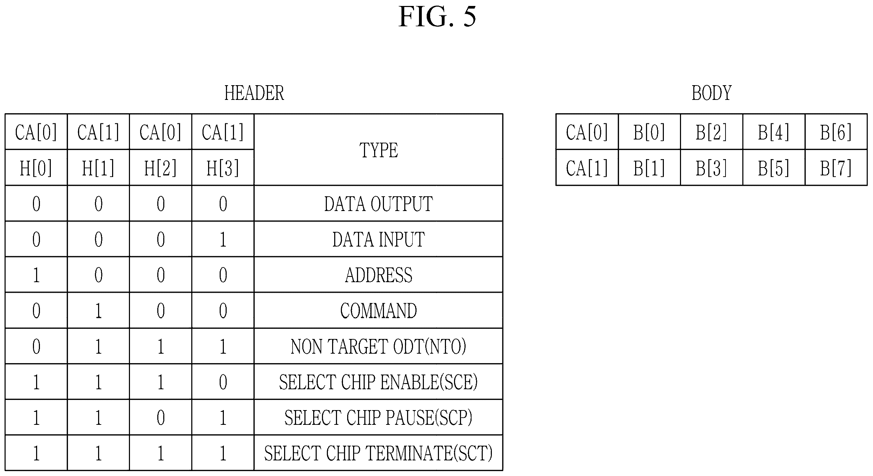

FIG. 5 is a drawing for explaining a header and a body included in the CA packet according to an embodiment.

Referring to FIG. 5, the CA packet transmitted through the command/address line CA may include a header HEADER and a body BODY. The header HEADER may include the zero-th to third headers H[0] to H[3]. The 0-th header H[0] and the second header H[2] may be transmitted to the first to fourth non-volatile memory devices 1110, 1120, 1210, and 1220 through the zero-th command/address line CA[0]. The first header H[1] and the third header H[3] may be transmitted to the first to fourth non-volatile memory devices 1110, 1120, 1210, and 1220 through the first command/address line CA[1].

In an embodiment, the CA packet including bit values of the zero-th to third headers H[0] to H[3] corresponding to "0000" may correspond to the data output packet DATA OUTPUT. In an embodiment, the data output packet DATA OUTPUT may be a packet transmitted to the storage controller 1300 from the first to fourth non-volatile memory devices 1110, 1120, 1210, and 1220. The zero-th to seventh bodies B[0] to B[7] of the data output packet DATA OUTPUT may include the data to be provided to the storage controller 1300 through the command/address line CA from the first to fourth non-volatile memory devices 1110, 1120, 1210, and 1220.

In an embodiment, the CA packet including bit values of the zero-th to third headers H[0] to H[3] corresponding to "0001" may correspond to the data input packet DATA INPUT. In an embodiment, the data input packet DATA INPUT may be a packet transmitted to the first to fourth non-volatile memory devices 1110, 1120, 1210, and 1220 from the storage controller 1300. The zero-th to seventh bodies B[0] to B[7] of the data input packet DATA INPUT may include the data to be provided to the first to fourth non-volatile memory devices 1110, 1120, 1210, and 1220 through the command/address line CA from the storage controller 1300.

In an embodiment, the CA packet including bit values of the zero-th to third headers H[0] to H[3] corresponding to "1000" may correspond to an address packet ADDRESS. The zero-th to seventh bodies B[0] to B[7] of the address packet ADDRESS may include the data that represents addresses of the first to fourth non-volatile memory devices 1110, 1120, 1210, and 1220.

In an embodiment, the CA packet including bit values of the zero-th to third headers H[0] to H[3] corresponding to "0100" may correspond to a command packet COMMAND. The zero-th to seventh bodies B[0] to B[7] of the command packet COMMAND may include data representing the type of the command. In an embodiment, the zero-th to seventh bodies B[0] to B[7] of the command packet COMMAND may include the data representing that the command packet COMMAND is the program command, the read command, the erase command, or a set feature command.

In an embodiment, the CA packet including bit values of the zero-th to third headers H[0] to H[3] corresponding to "0111" may correspond to a non-target ODT command packet NON TARGET ODT (NTO). The non-target ODT command packet NON TARGET ODT (NTO) may be a packet that enables or disables the first to fourth on-die termination circuits 160, 160a, 160b, and 160c included in the first to fourth non-volatile memory devices 1110, 1120, 1210, and 1220, respectively.

In an embodiment, the zero-th to seventh bodies B[0] to B[7] of the non-target ODT command packet NON TARGET ODT (NTO) may include the information on the non-volatile memory device to transmit the non-target ODT command packet NON TARGET ODT (NTO) and information for enabling or disabling the on-die termination circuit.

In an embodiment, the non-target ODT command packet NON TARGET ODT (NTO) may correspond to the ODT enable command, the ODT disable command, the target ODT enable command, or the target ODT disable command according to information included in the zero-th to seventh bodies B[0] to B[7].

In an embodiment, the ODT enable command may be a command to enable the first to fourth on-die termination circuits 160, 160a, 160b, and 160c included in the first to fourth non-volatile memory devices 1110, 1120, 1210, and 1220. In an embodiment, the non-target ODT command packet NON TARGET ODT (NTO) including the information on the first to fourth non-volatile memory devices 1110, 1120, 1210, and 1220 and the information for enabling the on-die termination circuit may correspond to the ODT enable command.

In an embodiment, the target ODT enable command may be a command to enable a target on-die termination circuit among the first to fourth on-die termination circuits 160, 160a, 160b, and 160c included in the first to fourth non-volatile memory devices 1110, 1120, 1210, and 1220. In an embodiment, the non-target ODT command packet NON TARGET ODT (NTO) including the information on a target non-volatile memory device among the first to fourth non-volatile memory devices 1110, 1120, 1210, and 1220 and the information for enabling the target on-die termination circuit included in the target non-volatile memory device may correspond to the target ODT enable command.

In an embodiment, the ODT disable command may be a command to disable the first to fourth on-die termination circuits 160, 160a, 160b, and 160c included in the first to fourth non-volatile memory devices 1110, 1120, 1210, and 1220. In an embodiment, the non-target ODT command packet NON TARGET ODT (NTO) including the information on the first to fourth non-volatile memory devices 1110, 1120, 1210, and 1220 and the information for disabling the on-die termination circuit may correspond to the ODT disable command.

In an embodiment, the target ODT disable command may be a command to disable the target on-die termination circuit among the first to fourth on-die termination circuits 160, 160a, 160b, and 160c included in the first to fourth non-volatile memory devices 1110, 1120, 1210, and 1220. In an embodiment, the non-target ODT command packet NON TARGET ODT (NTO) including the information on the target non-volatile memory device among the first to fourth non-volatile memory devices 1110, 1120, 1210, and 1220 and the information for disabling the target on-die termination circuit included in the target non-volatile memory device may correspond to the target ODT disable command.

In an embodiment, the CA packet including bit values of the zero-th to third headers H[0] to H[3] corresponding to "1110" may correspond to a selection chip enable command SELECT CHIP ENABLE (SCE). The selection chip enable command SELECT CHIP ENABLE (SCE) may be a command for selecting the non-volatile memory device for outputting the data. The zero-th to seventh bodies B[0] to B[7] of the selection chip enable command SELECT CHIP ENABLE (SCE) may include the information on the non-volatile memory device to transmit the selection chip enable command SELECT CHIP ENABLE (SCE). Herein, for convenience of description, the terms of the selection chip enable command SCE and a selection chip enable (SCE) command may be used interchangeably.

In an embodiment, the CA packet including bit values of the zero-th to third headers H[0] to H[3] corresponding to "1101" may correspond to a selection chip pause command SELECT CHIP PAUSE (SCP). The zero-th to seventh bodies B[0] to B[7] of the selection chip pause command SELECT CHIP PAUSE (SCP) may include the information on the non-volatile memory device to transmit the selection chip pause command SELECT CHIP PAUSE (SCP).

In an embodiment, the CA packet including bit values of the zero-th to third headers H[0] to H[3] corresponding to "1111" may correspond to a selection chip termination command SELECT CHIP TERMINATE (SCT). The selection chip termination command SELECT CHIP TERMINATE (SCT) may be a packet for terminating the data output from the non-volatile memory device. The zero-th to seventh bodies B[0] to B[7] of the selection chip termination command SELECT CHIP TERMINATE (SCT) may include the information on the non-volatile memory device to transmit the selection chip termination command SELECT CHIP TERMINATE (SCT). Herein, for convenience of description, the terms of the selection chip termination command SCT and a selection chip termination (SCT) command may be used interchangeably.

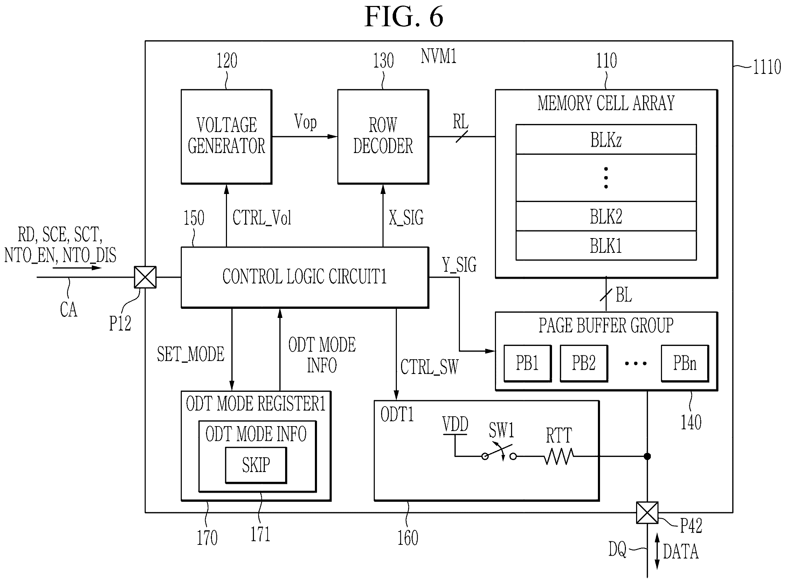

FIG. 6 is a drawing for explaining the first non-volatile memory device according to an embodiment.

Referring to FIG. 6, the first non-volatile memory device 1110 may include a memory cell array 110, a voltage generator 120, a row decoder 130, a page buffer group 140, the first control logic circuit 150, the first on-die termination circuit 160, the first ODT mode register 170.

The memory cell array 110 may include a plurality of memory blocks BLK1 to BLKz, z is a natural number of 2 or greater. The plurality of memory blocks BLK1 to BLKz may be connected to the row decoder 130 through row lines RL. The plurality of memory blocks BLK1 to BLKz may be connected to the page buffer group 140 through bitlines BL.

Each of the plurality of memory blocks BLK1 to BLKz may include the plurality of memory cells. In an embodiment, the plurality of memory cells may be non-volatile memory cells. In an embodiment, the plurality of memory cells may store the data received from the storage controller 1300.

The voltage generator 120 may generate operating voltages Vop by using an external power source voltage supplied at the first non-volatile memory device 1110. The voltage generator 120 may operate in response to the control of the first control logic circuit 150.

In an embodiment, the voltage generator 120 may generate the operating voltages Vop used for the program operation, the read operation, and the erase operation. For example, the voltage generator 120 may generate a program voltage, a pass voltage, a read voltage, and an erase voltage. The operating voltages Vop may be supplied to the memory cell array 110 from the row decoder 130.

The row decoder 130 may be connected to the memory cell array 110 through the row lines RL. The row lines RL may include string selection lines, wordlines, and ground selection lines.

The row decoder 130 may be configured to operate in response to the control of the first control logic circuit 150. The row decoder 130 may receive a row signal X_SIG from the first control logic circuit 150. In an embodiment, the row decoder 130 may select at least one wordline from among a plurality of wordlines based on the row signal X_SIG, and may apply the operating voltages Vop provided from the voltage generator 120 to at least one wordline.

In an embodiment, at the time of the program operation, the row decoder 130 may apply the program voltage to the selected wordline among the plurality of wordlines, and apply the pass voltage having a lower level than the program voltage, to the non-selected wordlines. At the time of a program verification operation, the row decoder 130 may apply a verification voltage to the selected wordline, and apply a verification pass voltage having a higher level than the verification voltage, to the non-selected wordlines.

At the time of the read operation, the row decoder 130 may apply the read voltage to the selected wordline, and apply a read pass voltage having a higher level than the read voltage to the non-selected wordlines.

The page buffer group 140 may include a plurality of page buffers PB1 to PBn, n is a natural number of 3 or greater. The plurality of page buffers PB1 to PBn may be connected to the plurality of memory cells included in the memory cell array 110 through the bitlines BL, respectively. The plurality of page buffers PB1 to PBn may operate in response to the control of the first control logic circuit 150.

In an embodiment, the plurality of page buffers PB1 to PBn may receive the data DATA from the storage controller 1300 through the data line DQ connected to the forty-second pin P42. The plurality of page buffers PB1 to PBn may select at least one bitline from among the bitlines BL based on a column signal Y_SIG received from the first control logic circuit 150.

In an embodiment, at the time of the program operation, the plurality of page buffers PB1 to PBn may transfer the data received from the outside to a plurality of memory cells of the memory cell array 110 through the bitlines BL. The memory cells may be programmed according to the received data. The plurality of page buffers PB1 to PBn may sense the data stored in the plurality of memory cells through at the time of the program verification operation, the bitlines BL.

At the time of the read operation, the plurality of page buffers PB1 to PBn may sense the data stored in the memory cells through the bitlines BL, and store the sensed data in the plurality of page buffers PB1 to PBn.

The first on-die termination circuit 160 may be connected to the data line DQ through which the data are input and/or output. In an embodiment, the first on-die termination circuit 160 may include a power source voltage VDD, a first switch SW1, and a termination resistor RTT. The first on-die termination circuit 160 may perform the termination operation according to control of the first control logic circuit 150. The termination operation may include the ODT enable operation and the ODT disable operation. The ODT enable operation may be an operation in which the first switch SW1 is closed, and the termination resistor RTT connected to the data line DQ is connected to the power source voltage VDD. The ODT disable operation may be an operation in which the first switch SW1 is opened, and the connection between the termination resistor RTT and the power source voltage VDD is blocked. The first switch SW1 may be opened or closed according to a switch control signal CTRL_SW received from the first control logic circuit 150.

The first ODT mode register 170 may store ODT operation mode information 171 on whether to perform the termination operation. The ODT operation mode information 171 may include the ODT operation information corresponding to the performing of the termination operation or the ODT skip information corresponding to the skip of the termination operation. The ODT operation information OPERATION or the ODT skip information SKIP may be set as the ODT operation mode information 171 according to a mode setting signal SET_MODE received from the first control logic circuit 150.

The first control logic circuit 150 may be connected to the voltage generator 120, the row decoder 130, the page buffer group 140, the first on-die termination circuit 160, and the first ODT mode register 170.

The first control logic circuit 150 may control an overall operation of the first non-volatile memory device 1110. The first control logic circuit 150 may control the voltage generator 120, the row decoder 130, the page buffer group 140, the first on-die termination circuit 160, and the first ODT mode register 170 to perform an operation corresponding to the command in response to the command received from the storage controller 1300.

In an embodiment, the first control logic circuit 150 may receive commands from the storage controller 1300 through the command/address line CA connected to the twelfth pin P12. In an embodiment, the first control logic circuit 150 may receive a read command RD from the storage controller 1300, and may control the voltage generator 120, the row decoder 130, and the page buffer group 140 to perform the read operation in response to the read command RD. The read operation may be an operation for sensing the data stored in the plurality of memory cells included in the memory cell array 110 by the plurality of page buffers PB1 to PBn.

In an embodiment, the first control logic circuit 150 may receive a selection chip enable command SCE from the storage controller 1300, and may control the plurality of page buffers PB1 to PBn to output the data sensed by the plurality of page buffers PB1 to PBn to the storage controller 1300 through the data line DQ in response to the selection chip enable command SCE.

In an embodiment, the first control logic circuit 150 may identify the ODT operation mode information 171 stored in the first ODT mode register 170 in response to the selection chip enable command SCE and a selection chip termination command SCT received from the storage controller 1300, and may control the first on-die termination circuit 160 to perform the termination operation based on the ODT operation mode information 171.

In an embodiment, when the ODT operation mode information 171 stored in the first ODT mode register 170 includes the ODT skip information, the first control logic circuit 150 may not perform the termination operation even if the selection chip enable command SCE and the selection chip termination command SCT are received.

In an embodiment, when the ODT operation mode information 171 stored in the first ODT mode register 170 includes the ODT operation information, the first control logic circuit 150 may control the first on-die termination circuit 160 to perform the ODT disable operation in response to the selection chip enable command SCE. In an embodiment, the first control logic circuit 150 may provide the switch control signal CTRL_SW for opening the first switch SW1 to the first on-die termination circuit 160 in response to the selection chip enable command SCE.

In an embodiment, when the ODT operation mode information 171 stored in the first ODT mode register 170 includes the ODT operation information, the first control logic circuit 150 may control the first on-die termination circuit 160 to perform the ODT enable operation in response to the selection chip termination command SCT. In an embodiment, the first control logic circuit 150 may provide the switch control signal CTRL_SW for closing the first switch SW1 to the first on-die termination circuit 160 in response to the selection chip termination command SCT.

In an embodiment, the first control logic circuit 150 may control the first on-die termination circuit 160 to perform the ODT enable operation in response to a command NTO_EN to enable the on-die termination circuit. The command NTO_EN to enable the on-die termination circuit may be the ODT enable command or the target ODT enable command described with reference to FIG. 5.

In an embodiment, the first control logic circuit 150 may control the first on-die termination circuit 160 to perform the ODT disable operation in response to a command NTO_DIS to disable the on-die termination circuit. The command NTO_DIS to disable the on-die termination circuit may be the ODT disable command or the target ODT disable command described with reference to FIG. 5.

In an embodiment, the first non-volatile memory device 1110 is described with reference to FIG. 6 as a mere example, and the second to the fourth non-volatile memory devices 1120, 1210, and 1220 of FIG. 1 may also operate in the same way as the first non-volatile memory device 1110 described with reference to FIG. 6.

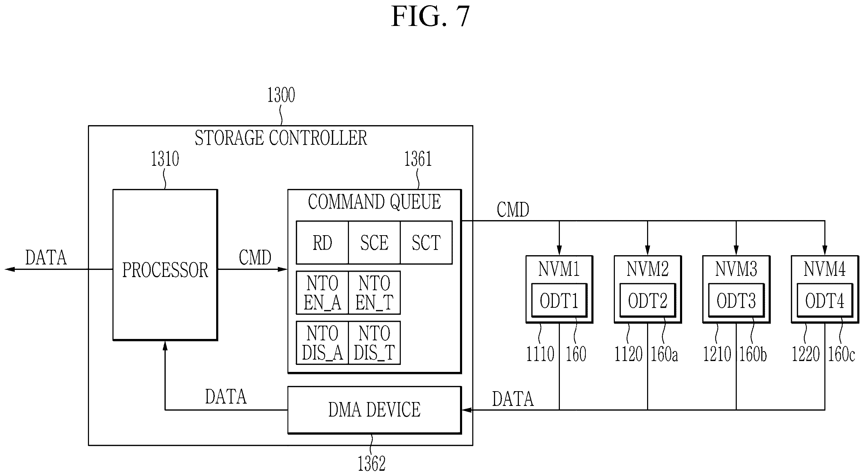

FIG. 7 is a drawing for explaining the storage device for performing the read operation, a data output operation, and a termination operation according to an embodiment.

With reference to FIG. 7, the case will be described as an example, in which the ODT operation mode information 171, 171a, 171b, and 171c stored in the first to fourth ODT mode registers 170, 170a, 170b, and 170c included in the first to fourth non-volatile memory devices 1110, 1120, 1210, and 1220, respectively, include the ODT skip information SKIP, and a first data output operation in which the first non-volatile memory device 1110 outputs the data is performed. Referring to FIG. 7, the storage device 1000 may include the storage controller 1300 and the first to fourth non-volatile memory devices 1110, 1120, 1210, and 1220. The storage controller 1300 may include the processor 1310, the command queue 1361, and the DMA device 1362. The first to fourth non-volatile memory devices 1110, 1120, 1210, and 1220 may include the first to fourth on-die termination circuits 160, 160a, and 160b, and 160c, respectively.

In an embodiment, the processor 1310 may generate a plurality of commands CMD, and may provide the plurality of commands CMD to the command queue 1361. The command queue 1361 may store the plurality of commands CMD received from the processor 1310. The plurality of commands CMD may include the read command RD, the selection chip enable command SCE, the selection chip termination command SCT, an ODT enable command NTO EN_A, a target ODT enable command NTO EN_T, an ODT disable command NTO DIS_A, and a target ODT disable command NTO DIS_T.

In an embodiment, the processor 1310 may control the command queue 1361 to provide a plurality of commands CMD stored in the command queue 1361 to the first to fourth non-volatile memory devices 1110, 1120, 1210, and 1220.

In an embodiment, the processor 1310 may control the command queue 1361 to provide the read command RD to the first non-volatile memory device 1110. The first non-volatile memory device 1110 may perform the read operation for sensing the data stored in the plurality of memory cells by the plurality of page buffers in response to the read command RD.

In an embodiment, the processor 1310 may provide the read command RD to the first non-volatile memory device 1110, and then may control the command queue 1361 to provide the ODT enable command NTO EN_A, by which the first to fourth on-die termination circuits 160, 160a, 160b, and 160c are enabled, to the first to fourth non-volatile memory devices 1110, 1120, 1210, and 1220. The first to fourth on-die termination circuits 160, 160a, 160b, and 160c may perform the ODT enable operation in response to the ODT enable command NTO EN_A.

In an embodiment, the processor 1310 may provide the ODT enable command NTO EN_A to the first to fourth non-volatile memory devices 1110, 1120, 1210, and 1220, and then may control the command queue 1361 provide the target ODT disable command NTO DIS_T by which the first on-die termination circuit 160 is disabled, to the first non-volatile memory device 1110. The first on-die termination circuit 160 may perform the ODT disable operation in response to the target ODT disable command NTO DIS_T.

In an embodiment, the processor 1310 may provide the target ODT disable command NTO DIS_T to the first non-volatile memory device 1110, and then may control the command queue 1361 to provide the selection chip enable command SCE to the first non-volatile memory device 1110. The first non-volatile memory device 1110 may perform the first data output operation for outputting the data DATA sensed from the plurality of page buffers to the DMA device 1362 in response to the selection chip enable command SCE. While the first non-volatile memory device 1110 is performing the first data output operation, the first on-die termination circuit 160 may be disabled, and the second to fourth on-die termination circuits 160a, 160b, and 160c may be enabled. The processor 1310 may receive the data output from the first non-volatile memory device 1110 through the DMA device 1362, and may provide the received data to the host 2000.

In an embodiment, the processor 1310 may provide the selection chip enable command SCE to the first non-volatile memory device 1110, and then may control the command queue 1361 to provide the selection chip termination command SCT to the first non-volatile memory device 1110. The first non-volatile memory device 1110 may terminate the first data output operation in response to the selection chip termination command SCT.

In an embodiment, the processor 1310 may provide the selection chip termination command SCT to the first non-volatile memory device 1110, and then may control the command queue 1361 provide the target ODT enable command NTO EN_T by which the first on-die termination circuit 160 is enable, to the first non-volatile memory device 1110. The first on-die termination circuit 160 may perform the ODT enable operation in response to the target ODT enable command NTO EN_T.

In an embodiment, the processor 1310 may provide the target ODT enable command NTO EN_T to the first non-volatile memory device 1110, and then may provide the ODT disable command NTO DIS_A to disable the first to fourth on-die termination circuits 160, 160a, 160b, and 160c to the first to fourth non-volatile memory devices 1110, 1120, 1210, and 1220. The first to fourth on-die termination circuits 160, 160a, 160b, and 160c may perform the ODT disable operation in response to the ODT disable command NTO DIS_A.

In an embodiment, while the first non-volatile memory device 1110 is performing the first data output operation, the processor 1310 may control the command queue 1361 to sequentially output the ODT enable command NTO EN_A, the target ODT disable command NTO DIS_T, the selection chip enable command SCE, the selection chip termination command SCT, the target ODT enable command NTO EN_T, and the ODT disable command NTO DIS_A in order to decrease the phenomenon in which the signal reflected from the second to fourth non-volatile memory devices 1120, 1210, and 1220 affects the data output from the first non-volatile memory device 1110.

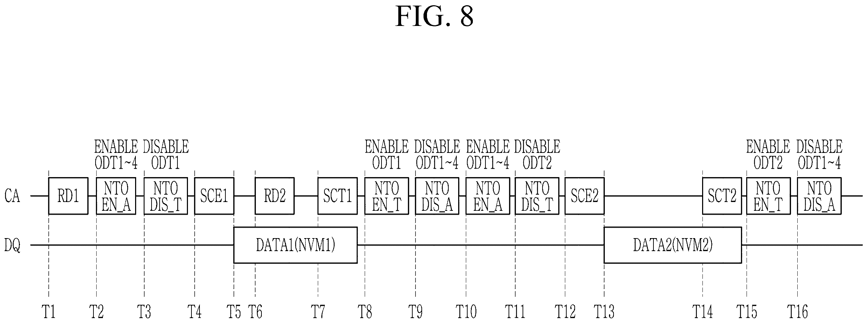

FIG. 8 is a drawing for explaining the non-volatile memory device disabling the on-die termination circuit in response to a target on-die termination (ODT) disable command, and outputting the data in response to the selection chip enable command, according to an embodiment.

With reference to FIG. 8, the case will be described as a mere example, in which the ODT operation mode information 171, 171a, 171b, and 171c stored in the first to fourth ODT mode registers 170, 170a, 170b, and 170c included in the first to fourth non-volatile memory devices 1110, 1120, 1210, and 1220, respectively, includes the ODT skip information SKIP, and the first data output operation in which the first non-volatile memory device 1110 outputs a first data DATA1 and the second data output operation in which the second non-volatile memory device 1120 outputs a second data DATA2 is performed.

Referring to FIG. 8, the storage controller 1300 may provide a plurality of read commands, a plurality of ODT enable commands, a plurality of target ODT enable commands, a plurality of ODT disable commands, a plurality of target ODT disable commands, a plurality of selection chip enable commands, a plurality of selection chip termination commands to the first and second non-volatile memory devices 1110 and 1120 through the command/address line CA in order to obtain the data from the first and second non-volatile memory devices 1110 and 1120. The storage controller 1300 may receive the first and second data DATA1 and DATA2 from the first and second non-volatile memory devices 1110 and 1120 through the data line DQ.

In an embodiment, at a time point T1, the storage controller 1300 may provide a first read command RD1 to the first non-volatile memory device 1110.

In an embodiment, at a time point T2, the storage controller 1300 may provide the ODT enable command NTO EN_A, by which the first to fourth on-die termination circuits 160, 160a, 160b, and 160c are enabled, to the first to fourth non-volatile memory devices 1110, 1120, 1210, and 1220.

In an embodiment, at a time point T3, the storage controller 1300 may provide the target ODT disable command NTO DIS_T by which the first on-die termination circuit 160 is disabled, to the first non-volatile memory device 1110.

In an embodiment, at a time point T4, the storage controller 1300 may provide a first selection chip enable command SCE1 to the first non-volatile memory device 1110.

In an embodiment, at a time point T5, the first non-volatile memory device 1110 may output the first data DATA1 sensed by the plurality of page buffers to the storage controller 1300 in response to the first selection chip enable command SCE.

In an embodiment, at a time point T6, the storage controller 1300 may provide a second read command RD2 to the second non-volatile memory device 1120, and at a time point T7, may provide a first selection chip termination command SCT1 to the first non-volatile memory device 1110. The second non-volatile memory device 1120 may perform the read operation for sensing the data stored in the plurality of memory cells included in the second non-volatile memory device 1120 by the plurality of page buffers included in the second non-volatile memory device 1120 in response to the second read command RD2. The first non-volatile memory device 1110 may terminate output of the first data DATA1 in response to the first selection chip termination command SCT1.

In an embodiment, at a time point T8, the storage controller 1300 may provide the target ODT enable command NTO EN_T by which the first on-die termination circuit 160 is enabled, to the first non-volatile memory device 1110.

In an embodiment, at a time point T9, the storage controller 1300 may provide the ODT disable command NTO DIS_A, by which the first to fourth on-die termination circuits 160, 160a, 160b, and 160c are disabled, to the first to fourth non-volatile memory devices 1110, 1120, 1210, and 1220.

In an embodiment, at a time point T10, the storage controller 1300 may provide the ODT enable command NTO EN_A, by which the first to fourth on-die termination circuits 160, 160a, 160b, and 160c are enabled, to the first to fourth non-volatile memory devices 1110, 1120, 1210, and 1220.

In an embodiment, at a time point T11, the storage controller 1300 may provide the target ODT disable command NTO DIS_T by which the second on-die termination circuit 160a is disabled, to the second non-volatile memory device 1120.

In an embodiment, at a time point T12, the storage controller 1300 may provide a second selection chip enable command SCE2 to the second non-volatile memory device 1120.

In an embodiment, at a time point T13, the second non-volatile memory device 1120 may output the second data DATA2 sensed by the plurality of page buffers of the second non-volatile memory device 1120 to the storage controller 1300 in response to the second selection chip enable command SCE2.

In an embodiment, at a time point T14, the storage controller 1300 may provide a second selection chip termination command SCT2 to the second non-volatile memory device 1120.

In an embodiment, at a time point T15, the storage controller 1300 may provide the target ODT enable command NTO EN_T by which the second on-die termination circuit 160a is enabled, to the second non-volatile memory device 1120.

In an embodiment, at a time point T16, the storage controller 1300 may provide the ODT disable command NTO DIS_A, by which the first to fourth on-die termination circuits 160, 160a, 160b, and 160c are disabled, to the first to fourth non-volatile memory devices 1110, 1120, 1210, and 1220.

In an embodiment, the storage controller 1300 may provide the ODT enable command NTO EN_A to enable a plurality of on-die termination circuits included in the plurality of non-volatile memory devices, respectively, to the plurality of non-volatile memory devices, before a first one non-volatile memory device among the plurality of non-volatile memory devices outputs the data.

In an embodiment, when the ODT operation mode information stored in a plurality of ODT mode registers included in the plurality of non-volatile memory devices, respectively, includes the ODT skip information, the storage controller 1300 may provide the target ODT disable command NTO DIS_T to disable the on-die termination circuit included in the non-volatile memory device to be output the data among the plurality of non-volatile memory devices.

In an embodiment, when the ODT operation mode information stored in the plurality of ODT mode registers included in the plurality of non-volatile memory devices, respectively, includes the ODT skip information, the storage controller 1300 may output the target ODT enable command NTO EN_T to enable the on-die termination circuit included in the non-volatile memory device which has been output the data among the plurality of non-volatile memory devices and the ODT disable command NTO DIS_A for disabling the plurality of on-die termination circuits included in the plurality of non-volatile memory devices, respectively.

In an embodiment, when the ODT operation mode information stored in the plurality of ODT mode registers included in the plurality of non-volatile memory devices, respectively, includes the ODT skip information, after a first one non-volatile memory device among the plurality of non-volatile memory devices outputs the data, the storage controller 1300 may output the ODT enable command NTO EN_A to enable the plurality of on-die termination circuits included in the plurality of non-volatile memory devices, respectively, before a second one non-volatile memory device outputs the data and the target ODT disable command NTO DIS_T to disable the on-die termination circuit included in the second one non-volatile memory device.

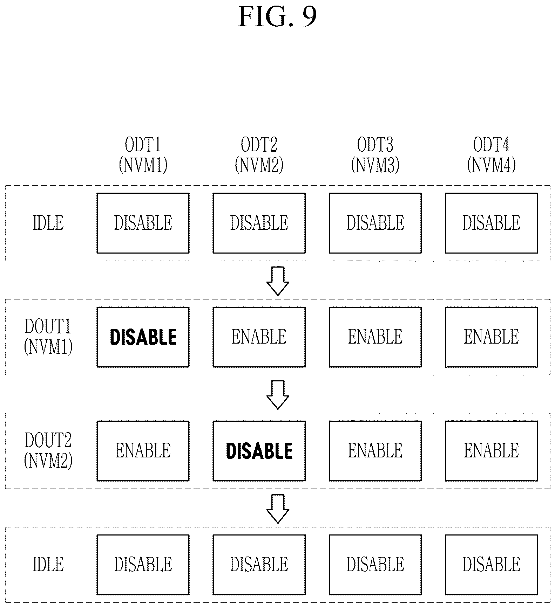

FIG. 9 is a drawing for explaining the plurality of on-die termination circuits enabled or disabled while performing the data output operation according to an embodiment.

FIG. 9 will be described with reference to FIG. 8. Referring to FIG. 9, the first to fourth on-die termination circuits 160, 160a, 160b, and 160c included in the first to fourth non-volatile memory devices 1110, 1120, 1210, and 1220, respectively, in an idle state IDLE may be at a disabled state. The disabled state may mean a state in which the connection of the power source voltage to the termination resistor included in the first to fourth on-die termination circuits 160, 160a, and 160b, and 160c, respectively, and connected to the data line DQ is blocked.

In an embodiment, after the idle state IDLE, the first non-volatile memory device 1110 may output the data in response to the first selection chip enable command SCE1. While performing the first data output operation DOUT1 in which the first non-volatile memory device 1110 outputs the data, the first on-die termination circuit 160 included in the first non-volatile memory device 1110 may be the disabled state, and the second to fourth on-die termination circuits 160a, 160b, and 160c included in the second to fourth non-volatile memory devices 1120, 1210, and 1220 may be an enabled state.

In an embodiment, after the first non-volatile memory device 1110 performs the first data output operation DOUT1, the second non-volatile memory device 1120 may output the data in response to the second selection chip enable command SCE2. While the second non-volatile memory device 1120 is outputting the data, the second on-die termination circuit 160a included in the second non-volatile memory device 1120 may be the disabled state, and the first on-die termination circuit 160, the third on-die termination circuit 160b, and the fourth on-die termination circuit 160c may be the enabled state.

In an embodiment, when the second non-volatile memory device 1120 performs the second data output operation DOUT2 and then become at the idle state IDLE, the first to fourth on-die termination circuits 160, 160a, 160b, and 160c may turn to the disabled state.

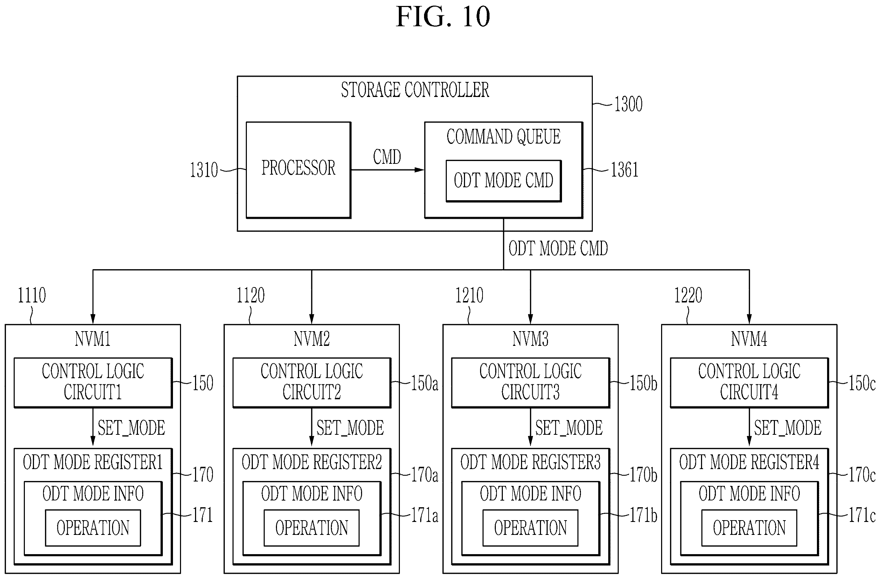

FIG. 10 is a drawing for explaining the plurality of non-volatile memory devices for changing the ODT operation mode information according to an ODT mode change command according to an embodiment.

Referring to FIG. 10, the first to fourth non-volatile memory devices 1110, 1120, 1210, and 1220 may include the first to fourth control logic circuits 150, 150a, 150b, and 150c, the first to fourth ODT mode registers 170, 170a, 170b, and 170c, respectively.

In an embodiment, the processor 1310 may generate an ODT operation mode change command ODT MODE CMD, and may provide the ODT operation mode change command ODT MODE CMD to the command queue 1361. In an embodiment, the ODT operation mode change command ODT MODE CMD may be a command to change the ODT operation mode information 171, 171a, 171b, and 171c stored in the first to fourth ODT mode registers 170, 170a, 170b, and 170c, respectively. In an embodiment, the ODT operation mode change command ODT MODE CMD may be the set feature command.

In an embodiment, the processor 1310 may control the command queue 1361 to provide the ODT operation mode change command ODT MODE CMD to the first to fourth non-volatile memory devices 1110, 1120, 1210, and 1220. The first to fourth control logic circuits 150, 150a, 150b, and 150c may change the ODT operation mode information 171, 171a, 171b, and 171c stored in the first to fourth ODT mode registers 170, 170a, 170b, and 170c, respectively, from the ODT skip information SKIP of FIG. 6 to the ODT operation information OPERATION, in response to the ODT operation mode change command ODT MODE CMD. The first to fourth ODT mode registers 170, 170a, 170b, and 170c may store the ODT operation information OPERATION as the ODT operation mode information 171, 171a, 171b, and 171c according to the mode setting signal SET_MODE received from the first to fourth control logic circuits 150, 150a, 150b, and 150c.

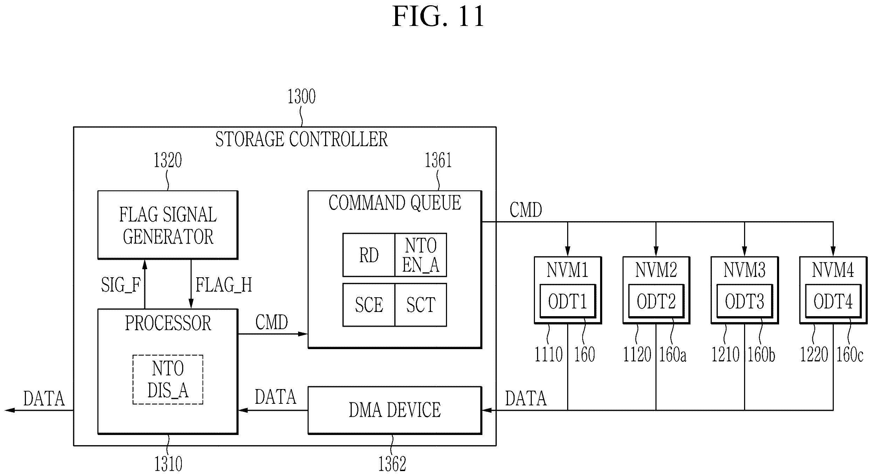

FIG. 11 is a drawing for explaining the storage controller activating the flag signal while providing commands to the plurality of non-volatile memory devices according to an embodiment.

With reference to FIG. 11, the case will be described as a mere example, in which the ODT operation mode information 171, 171a, 171b, and 171c stored in the first to fourth ODT mode registers 170, 170a, 170b, and 170c included in the first to fourth non-volatile memory devices 1110, 1120, 1210, and 1220, respectively, are changed to the ODT operation information OPERATION according to the ODT operation mode change command ODT MODE CMD described with reference to FIG. 10, and then the first data output operation in which the first non-volatile memory device 1110 outputs the data is performed.

Referring to FIG. 11, the processor 1310 may generate the plurality of commands CMD, and may provide the plurality of commands CMD to the command queue 1361. The plurality of commands CMD may include the read command RD, the ODT enable command NTO EN_A, the selection chip enable command SCE, and the selection chip termination command SCT.

In an embodiment, the processor 1310 may control the command queue 1361 to provide the read command RD to the first non-volatile memory device 1110. The first non-volatile memory device 1110 may perform the read operation in response to the read command RD.

In an embodiment, the processor 1310 may provide the read command RD to the first non-volatile memory device 1110, and then may control the command queue 1361 to provide the ODT enable command NTO EN_A, by which the first to fourth on-die termination circuits 160, 160a, 160b, and 160c are enabled, to the first to fourth non-volatile memory devices 1110, 1120, 1210, and 1220, respectively. The first to fourth on-die termination circuits 160, 160a, 160b, and 160c may perform the ODT enable operation in response to the ODT enable command NTO EN_A.

In an embodiment, the processor 1310 may provide the ODT enable command NTO EN_A to the first to fourth non-volatile memory devices 1110, 1120, 1210, and 1220, and then may control the command queue 1361 to provide the selection chip enable command SCE to the first non-volatile memory device 1110. The processor 1310 may provide the selection chip enable command SCE to the first non-volatile memory device 1110, and may provide a flag control signal SIG_F for activating the flag signal to the flag signal generator 1320. The flag signal generator 1320 may activate the flag signal in response to the flag control signal SIG_F. The flag signal generator may provide an activated flag signal FLAG_H to the processor 1310.

In an embodiment, the first non-volatile memory device 1110 may identify the ODT operation mode information 171 stored in the first ODT mode register 170 included in the first non-volatile memory device 1110 in response to the selection chip enable command SCE. When the ODT operation mode information 171 includes the ODT operation information OPERATION, the first non-volatile memory device 1110 may disable the first on-die termination circuit 160, in response to the selection chip enable command SCE, and may perform the first data output operation for outputting the data DATA sensed by the plurality of page buffers to the DMA device 1362 in the read operation.

In an embodiment, the processor 1310 may provide the selection chip enable command SCE to the first non-volatile memory device 1110, and then may provide the selection chip termination command SCT to the first non-volatile memory device 1110. The first non-volatile memory device 1110 may identify the ODT operation mode information 171 stored in the first ODT mode register 170 in response to the selection chip termination command SCT. When the ODT operation mode information 171 includes the ODT operation information OPERATION, the first non-volatile memory device 1110 may enable the first on-die termination circuit 160, in response to the selection chip termination command SCT, and may terminate the first data output operation.

In an embodiment, the processor 1310 may generate the ODT disable command NTO DIS_A, by which the first to fourth on-die termination circuits 160, 160a, 160b, and 160c are disabled based on whether the selection chip enable command SCE and the selection chip termination command SCT related to the first data output operation are stored in the command queue 1361. In an embodiment, when at least one selection chip enable command SCE and at least one selection chip termination command SCT are stored in the command queue 1361, the processor 1310 may not generate the ODT disable command NTO DIS_A and the ODT enable command NTO EN_A.

In an embodiment, the processor 1310 may control the flag signal generator 1320 to output the activated flag signal FLAG_H before providing the selection chip termination command SCT to the first non-volatile memory device 1110. The processor 1310 may skip generation of the ODT disable command NTO DIS_A while receiving the activated flag signal FLAG_H. For example, the ODT circuits may be disabled without the ODT disable command NTO DIS_A while receiving the activated flag signal FLAG_H.

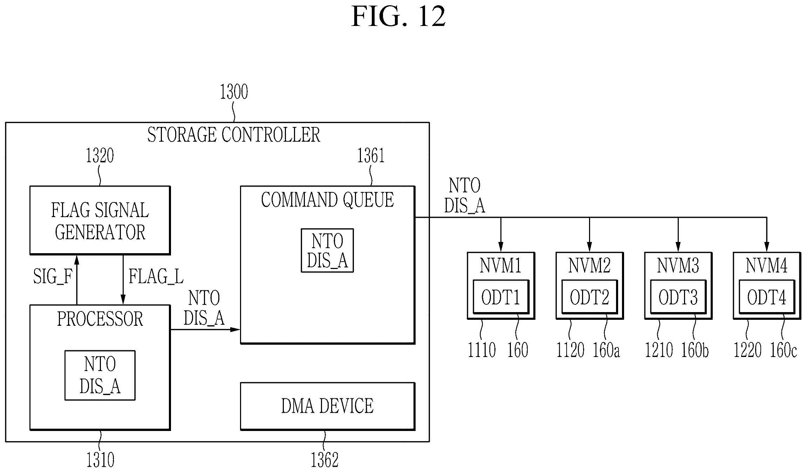

FIG. 12 is a drawing for explaining the storage controller generating the ODT disable command to disable the plurality of on-die termination circuits, when a flag signal according to an embodiment is inactivated.

Referring to FIG. 12, when the selection chip enable command SCE and the selection chip termination command SCT are not stored in the command queue 1361, the processor 1310 may generate the ODT disable command NTO DIS_A, by which the first to fourth on-die termination circuits 160, 160a, 160b, and 160c are disabled.

In an embodiment, the processor 1310 may provide the selection chip termination command SCT to the first non-volatile memory device 1110, and may provide the flag control signal SIG_F for inactivating then the flag signal to the flag signal generator 1320. The flag signal generator 1320 may inactivate the flag signal in response to the flag control signal SIG_F. The flag signal generator 1320 may output an inactivated flag signal FLAG_L.

In an embodiment, when the flag signal is inactivated, the processor 1310 may generate the ODT disable command NTO DIS_A, and may provide the ODT disable command NTO DIS_A to the command queue 1361. The processor 1310 may control the command queue 1361 to provide the ODT disable command NTO DIS_A to the first to fourth non-volatile memory devices 1110, 1120, 1210, and 1220.

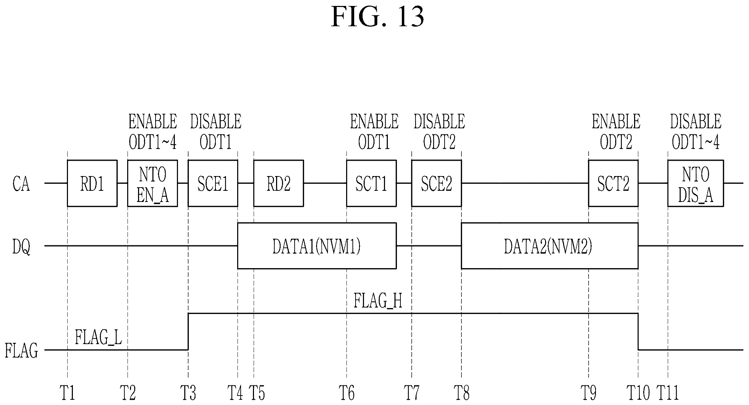

FIG. 13 is a drawing for explaining the non-volatile memory device disabling the on-die termination circuit and outputting the data in response to the selection chip enable command according to an embodiment.

With reference to FIG. 13, the case will be described as a mere example, in which the ODT operation mode information 171, 171a, 171b, and 171c stored in the first to fourth ODT mode registers 170, 170a, 170b, and 170c included in the first to fourth non-volatile memory devices 1110, 1120, 1210, and 1220, respectively, includes the ODT operation information OPERATION, and the first data output operation in which the first non-volatile memory device 1110 outputs the first data DATA1 and the second data output operation in which the second non-volatile memory device 1120 outputs the second data DATA2 are performed.

Referring to FIG. 13, at a time point T1, the storage controller 1300 may provide the first read command RD1 to the first non-volatile memory device 1110. The first non-volatile memory device 1110 may sense the first data DATA1 stored in the plurality of memory cells by the plurality of page buffers in response to the first read command RD1.

In an embodiment, at a time point T2, the storage controller 1300 may provide the ODT enable command NTO EN_A, by which the first to fourth on-die termination circuits 160, 160a, 160b, and 160c are enabled, to the first to fourth non-volatile memory devices 1110, 1120, 1210, and 1220. The first to fourth non-volatile memory devices 1110, 1120, 1210, and 1220 may enable the first to fourth on-die termination circuits 160, 160a, 160b, and 160c in response to the ODT enable command NTO EN_A.

In an embodiment, at a time point T3, the storage controller 1300 may provide the first selection chip enable command SCE1 to the first non-volatile memory device 1110. The storage controller 1300 may provide the first selection chip enable command SCE1 to the first non-volatile memory device 1110, and may activate the flag signal FLAG from the low level to the high level. The first non-volatile memory device 1110 may identify the ODT operation mode information 171 stored in the first ODT mode register 170 in response to the first selection chip enable command SCE1, and may disable the first on-die termination circuit 160 based on the ODT operation information OPERATION included in the ODT operation mode information 171. In an embodiment, the first non-volatile memory device 1110 may disable the first on-die termination circuit 160 in response to the first selection chip enable command SCE1 without the target ODT disable command NTO DIS_T. For example, the first selection chip enable command SCE1 from the storage controller 1300 may control the first on-die termination circuit 160 to be disabled.

In an embodiment, at a time point T4, the first non-volatile memory device 1110 may perform the first data output operation for outputting the first data DATA1 sensed by the plurality of page buffers to the storage controller 1300 in response to the first selection chip enable command SCE1.

In an embodiment, when the ODT operation mode information 171 include the ODT operation information OPERATION, the first non-volatile memory device 1110 disables the first on-die termination circuit 160 in response to the first selection chip enable command SCE1, and accordingly, the storage controller 1300 may not generate the target ODT disable command NTO DIS_T by which the first on-die termination circuit 160 is disabled.

In an embodiment, while the first non-volatile memory device 1110 is outputting the first data DATA1, the storage controller 1300 may provide a second read command RD2 to the second non-volatile memory device 1120, and may provide the first selection chip termination command SCT1 to the first non-volatile memory device 1110.

In an embodiment, at a time point T5, the storage controller 1300 may provide the second read command RD2 to the second non-volatile memory device 1120. The second non-volatile memory device 1120 may perform the read operation for sensing the second data DATA2 stored in a plurality of memory cells of the second non-volatile memory device 1120 by the plurality of page buffers of the second non-volatile memory device 1120 in response to the second read command RD2.

In an embodiment, at a time point T6, the storage controller 1300 may provide the first selection chip termination command SCT1 to the first non-volatile memory device 1110. The first non-volatile memory device 1110 may identify the ODT operation mode information 171 stored in the first ODT mode register 170 in response to the first selection chip termination command SCT1, and may enable the first on-die termination circuit 160 based on the ODT operation information OPERATION included in the ODT operation mode information 171. The first non-volatile memory device 1110 may terminate the first data output operation for outputting the first data DATA1 in response to the first selection chip termination command SCT1. In an embodiment, the first non-volatile memory device 1110 may enable the first on-die termination circuit 160 in response to the first selection chip termination command SCT1 without the target ODT enable command NTO EN_T. For example, the first selection chip termination command SCT1 from the storage controller 1300 may control the first on-die termination circuit 160 to be enabled.

In an embodiment, when the ODT operation mode information 171 include the operation information OPERATION, the first non-volatile memory device 1110 enables the first on-die termination circuit 160 in response to the first selection chip termination command SCT1, and accordingly, the storage controller 1300 may not generate the target ODT enable command NTO EN_T by which the first on-die termination circuit 160 is enabled.

In an embodiment, at a time point T7, the storage controller 1300 may provide the second selection chip enable command SCE2 to the second non-volatile memory device 1120. The second non-volatile memory device 1120 may identify the ODT operation mode information 171a stored in the second ODT mode register 170a in response to the second selection chip enable command SCE2, and may disable the second on-die termination circuit 160a based on the ODT operation information OEPRATION included in the ODT operation mode information 171a. In an embodiment, the second non-volatile memory device 1120 may disable the second on-die termination circuit 160a in response to the second selection chip enable command SCE2 without the target ODT disable command NTO DIS_T. For example, the second selection chip enable command SCE2 from the storage controller 1300 may control the second on-die termination circuit 160a to be disabled.

In an embodiment, at a time point T8, the second non-volatile memory device 1120 may perform the second data output operation for outputting the second data DATA2 sensed by the plurality of page buffers of the second non-volatile memory device 1120 to the storage controller 1300 in response to the second selection chip enable command SCE2.

In an embodiment, at a time point T9, the storage controller 1300 may provide the second selection chip termination command SCT2 to the second non-volatile memory device 1120. The second non-volatile memory device 1120 may identify the ODT operation mode information 171a stored in the second ODT mode register 170a in response to the second selection chip termination command SCT2, and may enable the second on-die termination circuit 160a based on the ODT operation information OEPRATION included in the ODT operation mode information 171a. The second non-volatile memory device 1120 may terminate the second data output operation in response to the second selection chip termination command SCT2. In an embodiment, the second non-volatile memory device 1120 may enable the second on-die termination circuit 160a in response to the second selection chip termination command SCT2 without the target ODT enable command NTO EN_T. For example, the second selection chip termination command SCT2 from the storage controller 1300 may control the second on-die termination circuit 160a to be enabled.

In an embodiment, at a time point T10, the second non-volatile memory device 1120 may terminate the second data output operation for outputting the second data DATA2 in response to the second selection chip termination command SCT2, and may inactivate then the flag signal FLAG from the high level to the low level.

In an embodiment, at a time point T11, when the selection chip enable command and the selection chip termination command are not stored in the command queue 1361, the storage controller 1300 may generate the ODT disable command NTO DIS_A, by which the first to fourth on-die termination circuits 160, 160a, 160b, and 160c are disabled. In an embodiment, the storage controller 1300 may generate the ODT disable command NTO DIS_A based on the inactivated flag signal FLAG, and may provide the ODT disable command NTO DIS_A to the first to fourth non-volatile memory devices 1110, 1120, 1210, and 1220.

In an embodiment, when at least one selection chip enable command and at least one selection chip termination command are stored in the command queue 1361, the storage controller 1300 may not generate the ODT disable command NTO DIS_A. For example, the storage controller 1300 may not generate the ODT disable command NTO DIS_A, before the second selection chip termination command SCT2 is provided from the command queue 1361 to the second non-volatile memory device 1120. For example, the storage controller 1300 may not generate the ODT disable command NTO DIS_A while the flag signal is activated.

In an embodiment, when the second read command RD2 provides to the second non-volatile memory device 1120 while the first read operation is performing in response to the first read command RD1, the storage controller 1300 may not generate the ODT disable command NTO DIS_A.

In an embodiment, the storage controller 1300 may generate the ODT disable command NTO DIS_A based on whether at least one selection chip enable command and at least one selection chip termination command are stored in the command queue, and accordingly, may skip the generation of the ODT disable command NTO DIS_A until the second selection chip termination command SCT2 for terminating the second data output operation is output.

In an embodiment, the storage controller 1300 may not generate the ODT disable command NTO DIS_A until the second selection chip termination command SCT2 is output, and may not generate the ODT enable command NTO EN_A that was being output during the section of to T11 of FIG. 8.

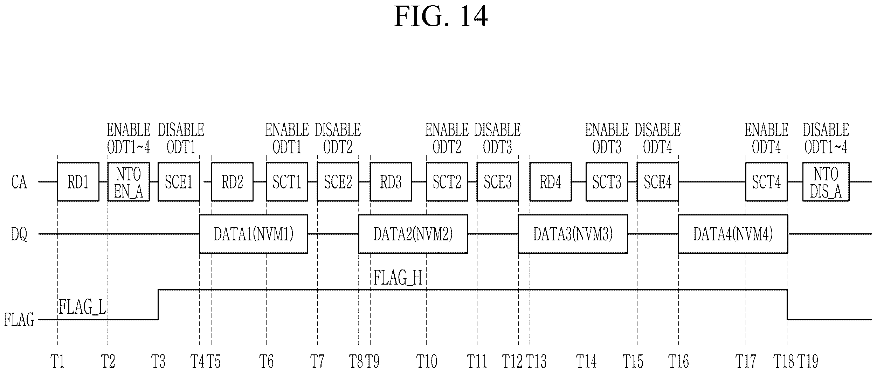

FIG. 14 is a drawing for explaining the plurality of non-volatile memory devices performing the read operation, the data output operation, the ODT enable operation, and the ODT disable operation according to commands received through a command/address line according to an embodiment.

With reference to FIG. 14, the case will be described as a mere example, in which the ODT operation mode information 171, 171a, 171b, and 171c stored in the first to fourth ODT mode registers 170, 170a, 170b, and 170c included in the first to fourth non-volatile memory devices 1110, 1120, 1210, and 1220, respectively, includes the ODT operation information OPERATION, and the first to fourth non-volatile memory devices 1110, 1120, 1210, and 1220 output first to fourth data DATA1 to DATA4.

Referring to FIG. 14, in a section of T1 to T3, the storage controller 1300 may provide the first read command RD1 to the first non-volatile memory device 1110, and may provide the ODT enable command NTO EN_A to the first to fourth non-volatile memory devices 1110, 1120, 1210, and 1220. The first to fourth non-volatile memory devices 1110, 1120, 1210, and 1220 may enable the first to fourth on-die termination circuits 160, 160a, 160b, and 160c in response to the ODT enable command NTO EN_A.

In an embodiment, in a section of T3 to T7, the storage controller 1300 may provide the first selection chip enable command SCE1 to the first non-volatile memory device 1110, may provide the second read command RD2 to the second non-volatile memory device 1120, and may provide the first selection chip termination command SCT1 to the first non-volatile memory device 1110. The storage controller 1300 may provide the first selection chip enable command SCE1 to the first non-volatile memory device 1110, and activate the flag signal FLAG to the high level.

In an embodiment, in a section of T4 to T7, the first non-volatile memory device 1110 may disable the first on-die termination circuit 160 in response to the first selection chip enable command SCE1, and may output the first data DATA1. While the first non-volatile memory device 1110 is outputting the first data DATA1, the first on-die termination circuit 160 may be the disabled state, and second to fourth on-die termination circuits 160a, 160b, and 160c may be the enabled state. The first non-volatile memory device 1110 may enable the first on-die termination circuit 160 in response to the first selection chip termination command SCT1, and may terminate output of the first data DATA1.

In an embodiment, in a section of T7 to T11, the storage controller 1300 may provide the second selection chip enable command SCE2 to the second non-volatile memory device 1120, and may provide a third read command RD3 to the third non-volatile memory device 1210, and may provide the second selection chip termination command SCT2 to the second non-volatile memory device 1120.

In an embodiment, in a section of T8 to T11, the second non-volatile memory device 1120 may disable the second on-die termination circuit 160a in response to the second selection chip enable command SCE2, and may output the second data DATA2. While the second non-volatile memory device 1120 is outputting the second data DATA2, the second on-die termination circuit 160a may be the disabled state, and the first on-die termination circuit 160, the third on-die termination circuit 160b, and the fourth on-die termination circuit 160c may be the enabled state. The second non-volatile memory device 1120 may enable the second on-die termination circuit 160a in response to a second selection chip termination command SCT2, and may terminate output of the second data DATA2.

In an embodiment, in a section of T11 to T15, the storage controller 1300 may provide a third selection chip enable command SCE3 to the third non-volatile memory device 1210, and may provide a fourth read command RD4 to the fourth non-volatile memory device 1220, and may provide a third selection chip termination command SCT3 to the third non-volatile memory device 1210.

In an embodiment, in a section of T12 to T15, the third non-volatile memory device 1210 may disable the third on-die termination circuit 160b in response to the third selection chip enable command SCE3, and may output the third data DATA3. While the third non-volatile memory device 1210 is outputting the third data DATA3, the third on-die termination circuit 160b may be the disabled state, and the first on-die termination circuit 160, the second on-die termination circuit 160a, and the fourth on-die termination circuit 160c may be the enabled state. The third non-volatile memory device 1210 may enable the third on-die termination circuit 160b in response to the third selection chip termination command SCT3, and may terminate output of the third data DATA3.

In an embodiment, in a section of T15 to T19, the storage controller 1300 may provide a fourth selection chip enable command SCE4 and a fourth selection chip termination command SCT4 to the fourth non-volatile memory device 1220. The storage controller 1300 may provide the fourth selection chip termination command SCT4 to the fourth non-volatile memory device 1220, and may inactivate the flag signal FLAG to the low level.

In an embodiment, in a section of T16 to T19, the fourth non-volatile memory device 1220 may disable the fourth on-die termination circuit 160c in response to the fourth selection chip enable command SCE4, and may output the fourth data DATA4. While the fourth non-volatile memory device 1220 is outputting the fourth data DATA4, the fourth on-die termination circuit 160c may be the disabled state, and the first to third on-die termination circuits 160, 160a, and 160b may be the enabled state.

In an embodiment, at a time point T19, the storage controller 1300 may provide the ODT disable command NTO DIS_A to the first to fourth non-volatile memory devices 1110, 1120, 1210, and 1220, and the first to fourth non-volatile memory devices 1110, 1120, 1210, and 1220 may disable the first to fourth on-die termination circuits 160, 160a, 160b, and 160c in response to the ODT disable command NTO DIS_A.

In an embodiment, when the first to fourth selection chip enable commands SCE1 to SCE4 and the first to fourth selection chip termination commands SCT1 to SCT4 are stored in the command queue 1361, the storage controller 1300 may not generate the ODT disable command NTO DIS_A.

In an embodiment, when the first to fourth selection chip enable commands SCE1 to SCE4 and the first to fourth selection chip termination commands SCT1 to SCT4 are not stored in the command queue 1361, the storage controller 1300 may generate the ODT disable command NTO DIS_A.

In an embodiment, after the fourth selection chip termination command SCT4 is provided to the fourth non-volatile memory device 1220, the storage controller 1300 may inactivate the flag signal FLAG to the low level, and may generate the ODT disable command NTO DIS_A based on the inactivated flag signal.

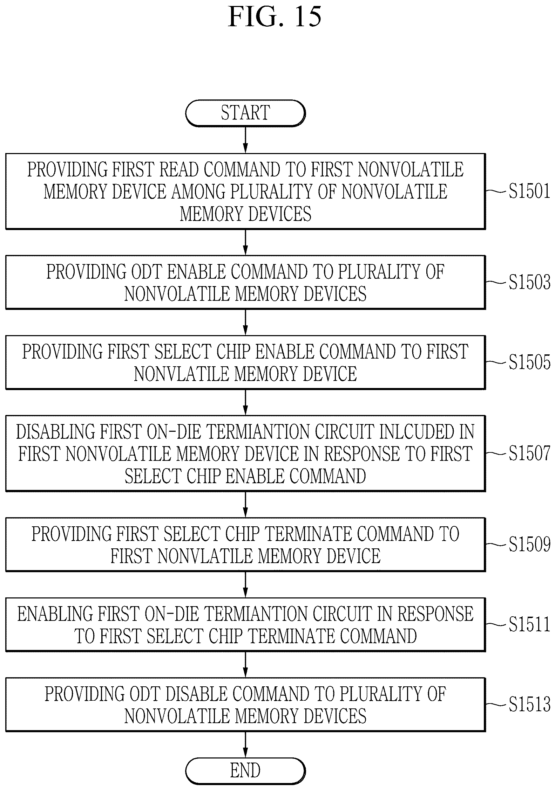

FIG. 15 is a flowchart for explaining the operation of the storage device according to an embodiment.

Referring to FIG. 15, at step S1501, the storage controller 1300 may provide the read command to the first non-volatile memory device 1110 among the plurality of non-volatile memory devices. The first non-volatile memory device 1110 may perform the read operation for sensing the data stored in the plurality of memory cells by the plurality of page buffers in response to the read command.

At step S1503, the storage controller 1300 may provide the ODT enable command to the plurality of non-volatile memory devices. The ODT enable command may be a command to enable the plurality of on-die termination circuits included in the plurality of non-volatile memory devices, respectively.

At step S1505, the storage controller 1300 may provide the first selection chip enable command to the first non-volatile memory device 1110.

At step S1507, the first non-volatile memory device 1110 may disable the first on-die termination circuit 160 included in the first non-volatile memory device 1110 in response to the first selection chip enable command. The first non-volatile memory device 1110 may output the data stored in the plurality of page buffers to the storage controller 1300 in response to the first selection chip enable command.

At step S1509, the storage controller 1300 may provide the first selection chip termination command to the first non-volatile memory device 1110.

At step S1511, the first non-volatile memory device 1110 may enable the first on-die termination circuit 160 in response to the first selection chip termination command.

At step S1513, the storage controller 1300 may provide the ODT disable command to the plurality of non-volatile memory devices. The ODT disable command may be a command to disable the plurality of on-die termination circuits included in the plurality of non-volatile memory devices, respectively.

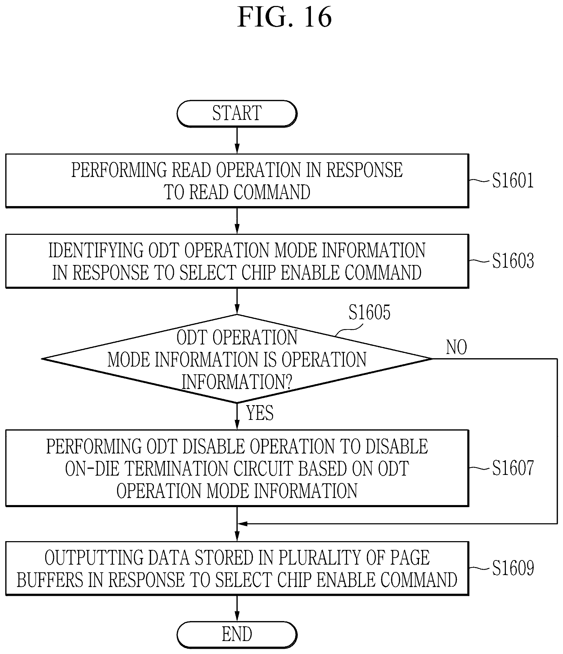

FIG. 16 is a flowchart for explaining the non-volatile memory device for performing the ODT disable operation in response to the selection chip enable command according to an embodiment.

At step S1601, the non-volatile memory device may perform the read operation in response to the read command.

At step S1603, the non-volatile memory device may identify the ODT operation mode information in response to the selection chip enable command. The ODT operation mode information may be stored in the ODT mode register. The ODT operation mode information may include information on whether the termination operation including the ODT enable operation and the ODT disable operation is performed. The ODT operation mode information may include the ODT operation information corresponding to the performing of the termination operation or the ODT skip information corresponding to the skip of the termination operation. The ODT operation mode information may be changed by the ODT operation mode change command received from the storage controller. For example, the ODT operation mode change command may be received before receiving the selection chip enable command.

At step S1605, the non-volatile memory device may identify whether the ODT operation mode information is the ODT operation information. When the ODT operation mode information includes the ODT operation information, S1607 may be performed. When the ODT operation mode information includes the ODT skip information, S1609 may be performed.

At step S1607, when the ODT operation mode information includes the ODT operation information, the non-volatile memory device may perform the ODT disable operation in which the on-die termination circuit is disabled based on the ODT operation mode information. The ODT disable operation may be an operation in which the connection between the termination resistor included in the on-die termination circuit and the power source voltage is blocked. The termination resistor may be connected to the data line through which the data are input and/or output.

At step S1609, the non-volatile memory device may output the data stored in the plurality of page buffers in response to the selection chip enable command.

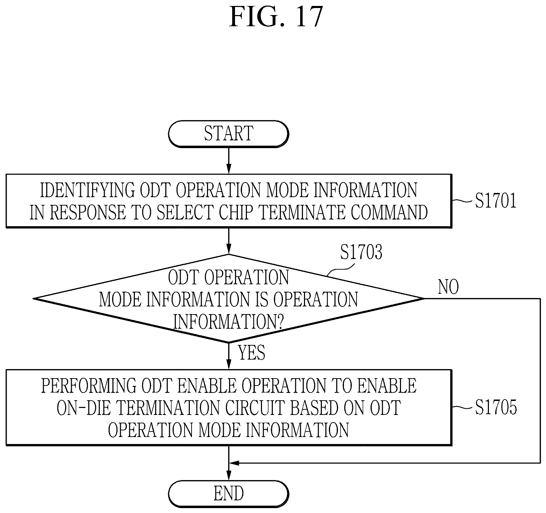

FIG. 17 is a flowchart for explaining the non-volatile memory device for performing the ODT enable operation in response to the selection chip termination command according to an embodiment.

Referring to FIG. 17, at step S1701, the non-volatile memory device may identify the ODT operation mode information in response to the selection chip termination command.

At step S1703, the non-volatile memory device may identify whether the ODT operation mode information is the ODT operation information. When the ODT operation mode information includes the ODT operation information, S1705 may be performed. When the ODT operation mode information includes the ODT skip information, the non-volatile memory device may not perform the termination operation.

At step S1705, when the ODT operation mode information includes the ODT operation information, the non-volatile memory device may perform the ODT enable operation in which the on-die termination circuit is enabled based on the ODT operation mode information. The ODT enable operation may be an operation in which the termination resistor included in the on-die termination circuit is connected to the power source voltage. Non-volatile memory device may terminate output of the data in response to the selection chip termination command.

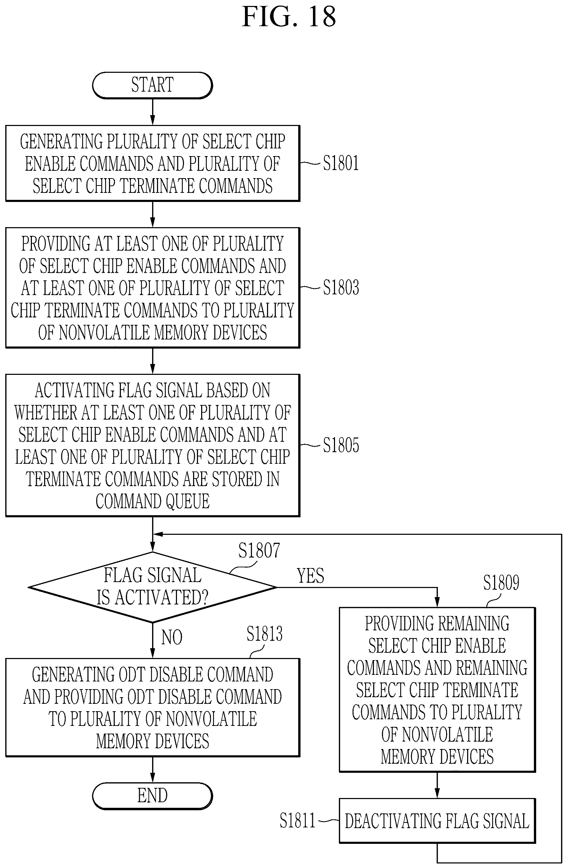

FIG. 18 is a flowchart for explaining the storage controller generating the ODT disable command based on the flag signal according to an embodiment.

Referring to FIG. 18, at step S1801, the storage controller 1300 may generate the plurality of selection chip enable commands and the plurality of selection chip termination commands.

At step S1803, the storage controller 1300 may provide at least one of the plurality of selection chip enable commands and at least one of the plurality of selection chip termination commands to the plurality of non-volatile memory devices.

At step S1805, the storage controller 1300 may activate the flag signal based on whether at least one of the plurality of selection chip enable commands and at least one of the plurality of selection chip termination commands are stored in the command queue. The flag signal may be activated while at least one of the plurality of selection chip enable commands and at least one of the plurality of selection chip termination commands are stored in the command queue. When the selection chip enable command and the selection chip termination command are not stored in the command queue, the flag signal may be inactivated.

At step S1807, the storage controller 1300 may identify whether the flag signal is activated. When the flag signal is activated, S1809 may be performed. When the flag signal is inactivated, S1813 may be performed.

At step S1809, when at least one of the plurality of selection chip enable commands and at least one of the plurality of selection chip termination commands are stored in the command queue, the storage controller 1300 may provide the remaining selection chip enable commands and the remaining selection chip termination commands stored in the command queue to the plurality of non-volatile memory devices.

At step S1811, the storage controller 1300 may inactivate the flag signal.

At step S1813, the storage controller 1300 may generate the ODT disable command, and may provide the ODT disable command to the plurality of non-volatile memory devices. The ODT disable command may be a command to disable the plurality of on-die termination circuits included in the plurality of non-volatile memory devices, respectively.

While the inventive concept has been particularly shown and described with reference to embodiments thereof, it will be understood that various changes in form and details may be made therein without departing from the scope of the present invention as set forth in the appended claims.

## Claims

1. A storage device (1000), comprising:
a plurality of non-volatile memory devices (1110, 1120, 1210, 1220) including an on-die termination, ODT, circuit (160, 160a, 160b, 160c), respectively; and
a storage controller (1300) configured to:
provide a first read command to a first non-volatile memory device (1110) among the plurality of non-volatile memory devices (1110, 1120, 1210, 1220),
provide an ODT enable command (NTO EN_A ) to the plurality of non-volatile memory devices (1110, 1120, 1210, 1220),
enable the ODT circuits (160, 160a, 160b, 160c) of the plurality of non-volatile memory devices (1110, 1120, 1210, 1220) in response to the ODT enable command (NTO EN_A ),
provide a first selection chip enable, SCE, command (SCE1) to the first non-volatile memory device (1110), and
in response to the first SCE command (SCE1):
disable a first ODT circuit (160) included in the first non-volatile memory device (1110) among the ODT circuits (160, 160a, 160b, 160c) of the plurality of non-volatile memory devices (1110, 1120, 1210, 1220), and
output data stored in the first non-volatile memory device (1110).

2. The storage device (1000) of claim 1, wherein, while receiving the data stored in the first non-volatile memory device (1110) through a data line, the storage controller (1300) is configured to:
provide a second read command to a second non-volatile memory device (1120) among the plurality of non-volatile memory devices (1110, 1120, 1210, 1220) through a command/address line, and
provide a first selection chip termination, SCT, command (SCT1) to the first non-volatile memory device (1110), the first SCT command (SCT1) configured to terminate the data output from the first non-volatile memory device (1110).

3. The storage device (1000) of claim 2, wherein the first non-volatile memory device (1110) is configured to enable the first ODT circuit (160) in response to the first SCT command (SCT1).

4. The storage device (1000) of claim 3, wherein the storage controller (1300) is configured to provide a second SCE command (SCE2) to the second non-volatile memory device (1120) after providing the first SCT command (SCT1) to the first non-volatile memory device (1110), and
wherein the second SCE command (SCE2) is configured to disable a second ODT circuit (160a) included in the second non-volatile memory device (1120).

5. The storage device (1000) of claim 3 or 4, wherein the storage controller (1300) comprise:
a command queue configured to store a plurality of SCE commands and a plurality of SCT commands to be provided to remaining non-volatile memory devices excluding the first non-volatile memory device (1110) from among the plurality of non-volatile memory devices (1110, 1120, 1210, 1220); and
a processor (1310) configured to activate a flag signal after providing the first SCE command (SCE1) to the first non-volatile memory device (1110), and inactivate the flag signal after providing the plurality of SCT commands to the remaining non-volatile memory devices.

6. The storage device (1000) of claim 5, wherein, while the flag signal is activated, the ODT circuits (160, 160a, 160b, 160c) of the plurality of non-volatile memory devices (1110, 1120, 1210, 1220) are configured to be disabled without an ODT disable command.

7. The storage device (1000) of claim 5 or 6, wherein, when the flag signal is inactivated, the processor (1310) is configured to generate an ODT disable command corresponding to disabling of the ODT circuits (160, 160a, 160b, 160c) of the plurality of non-volatile memory devices (1110, 1120, 1210, 1220), and provide the ODT disable command to the plurality of non-volatile memory devices (1110, 1120, 1210, 1220).

8. The storage device (1000) of any one of claims 1 to 7, wherein the first non-volatile memory device (1110) includes an ODT mode register (170) configured to store an ODT operation mode information (171) on whether to perform a termination operation including an ODT enable operation in which the first ODT circuit (160) is enabled and an ODT disable operation in which the first ODT circuit (160) is disabled, and
wherein the first ODT circuit (160) is configured to be disabled based on the ODT operation mode information (171) in response to the first SCE command (SCE1).

9. The storage device (1000) of claim 8, wherein the ODT operation mode information (171) includes ODT operation information corresponding to performing of the termination operation or ODT skip information corresponding to a skip of the termination operation.

10. A method of operating a memory device, comprising:
sensing data stored in a plurality of memory cells to a plurality of page buffers in response to a read command;
identifying On-Die Termination, ODT, operation mode information (171, 171a, 171b, 171c) regarding whether to perform a termination operation in which an on-die termination circuit (160, 160a, 160b, 160c) is enabled or disabled in response to a select chip enable command (SCE1-SCE4);
disabling the on-die termination circuit (160, 160a, 160b, 160c) based on the ODT operation mode information (171, 171a, 171b, 171c) in response to the select chip enable command (SCE1-SCE4); and
outputting data stored in the plurality of page buffers through a data line in response to the select chip enable command (SCE1-SCE4).

11. The method of operating the memory device according to claim 10, wherein
the ODT operation mode information (171, 171a, 171b, 171c) includes operation information corresponding to performing the termination operation or skip information corresponding to skipping the termination operation.

12. The method of operating the memory device according to claim 11, wherein
the operation information is set as the ODT operation mode information (171, 171a, 171b, 171c) in response to an ODT operation mode change command received before the select chip enable command (SCE1-SCE4).

13. The method of operating the memory device according to any one of claims 10 to 12, wherein
the on-die termination circuit (160, 160a, 160b, 160c) is enabled in response to an ODT enable command (NTO EN_A ) received before the select chip enable command (SCE1-SCE4).

14. The method of operating the memory device according to any one of claims 10 to 13, further comprising:
identifying the ODT operation mode information (171, 171a, 171b, 171c) in response to a select chip terminate command (SCT1- SCT4) received after the select chip enable command (SCE1-SCE4) is received; and
enabling the on-die termination circuit (160, 160a, 160b, 160c) based on the ODT operation mode information (171, 171a, 171b, 171c) in response to the select chip terminate command (SCT1- SCT4).

15. The method of operating the memory device according to any one of claims 10 to 14, wherein
the select chip terminate command (SCT1- SCT4) is received through a command/address line while the data stored in the plurality of page buffers is being output to outside through the data line.
